# EUROPÄISCHE PATENTSCHRIFT

(11) **EP 2 583 539 B1**
(45) Veröffentlichungstag und Bekanntmachung des Hinweises auf die Patenterteilung: **27.05.2015**
(21) Anmeldenummer: 11727647.7
(22) Anmeldetag: 11.06.2011
(51) Int. Cl.: H05K 1/16, H05K 3/38, H05K 3/30, G06K 19/077, H01L 23/498, H01Q 1/38, H01Q 7/00, H01Q 1/22

(54) **MEHRSCHICHTIGES FOLIENELEMENT**
MULTILAYERED FILM ELEMENT
ÉLÉMENT FILM MULTICOUCHE

(30) Priorität: 21.06.2010 DE 102010024523
(43) Veröffentlichungstag der Anmeldung: 24.04.2013
(73) Patentinhaber: Leonhard Kurz Stiftung & Co. KG, 90763 Fürth (DE)
(72) Erfinder: SCHINDLER, Ulrich, 90762 Fürth (DE); SCHUMACHER, Christian, 90768 Fürth (DE); MIESLINGER, Stefan, 84051 Essenbach (DE)
(74) Vertreter: Laub, Alexander
(86) Internationale Anmeldenummer: PCT/EP2011/002878
(87) Internationale Veröffentlichungsnummer: WO 2011/160782

(56) Entgegenhaltungen:
- DE-A1- 19 647 845
- DE-A1-102007 004 642
- US-A1- 2010 147 958

## Beschreibung

Die Erfindung betrifft ein mehrschichtiges Folienelement mit einem ersten Bauelement, insbesondere eine RFID-Antenne in Form eines mehrschichtigen Folienelements, sowie ein Verfahren zum Befestigen eines zweiten Bauelements auf einem solchen mehrschichtigen Folienelement (RFID = Radio Frequency Identification).

Ein RFID-Transponder umfasst zumindest eine Antenne und einen elektronischen Mikrochip, kurz "Chip" genannt, die auf einem Träger angeordnet sind. Bei einem bekannten Verfahren zur Herstellung eines RFID-Transponders wird zunächst ein Antennensubstrat, d. h. ein mehrschichtiges Folienelement umfassend ein Trägersubstrat und mindestens eine elektrisch leitfähige Schicht als RFID-Antenne, bereitgestellt und sodann die Antenne mit einem Transponder-Chip elektrisch verbunden. Eine weit verbreitete Art der Montage des Chips auf dem Antennensubstrat ist das Flip-Chip-Bonding. Dabei wird der Chip auf seiner aktiven Kontaktierungsseite ("chip bond pads") mit Kontakthöckern, sogenannten "Bumps", versehen, umgedreht - daher der Name Flip-Chip -, ausgerichtet und mit seiner Kontaktierungsseite so auf entsprechenden Chip-Kontaktflächen ("substrate bond pads") des Antennensubstrats angeordnet, dass ein elektrisch leitender Kontakt zwischen dem Chip und der Antenne hergestellt wird. Der Chip kann in einer alternativen Ausführung auf einem Verdrahtungselement, beispielsweise einem sogenannten "Strap", mechanisch befestigt und elektrisch kontaktiert sein, wobei das Verdrahtungselement seinerseits Kontaktelemente aufweist, die auf entsprechenden Chip-Kontaktflächen ("substrate bond pads") des Antennensubstrats angeordnet werden, sodass ein elektrisch leitender Kontakt zwischen dem Chip und der Antenne hergestellt wird.

Eine Heizeinrichtung, z. B. ein beheizbarer Druckstempel (Thermode), kann mit einem oder mehreren Bauteilen in Kontakt gebracht werden, um die Antenne und den Chip bzw. die Antenne und das Verdrahtungselement mit dem darauf montierten Chip dauerhaft miteinander mechanisch zu verbinden. Als "Verbindungsmittel" können hierbei geeignete Klebstoffe oder Lote zur Anwendung kommen. Beispielsweise kann im Bereich der Chip-Kontaktflächen vorab applizierter Klebstoff nach dem Platzieren des Flip-Chips oder des Verdrahtungselements mit dem darauf montierten Chip auf dem Antennensubstrat mittels einer Thermode aktiviert, z. B. ausgehärtet, werden. Auf diese Weise erfolgen mechanische Fixierung und elektrische Kontaktierung bei der Flip-Chip-Montage oder der Montage des Verdrahtungselements mit dem darauf montierten Chip in einem einzigen Prozessschritt. Zudem sind die elektrischen Kontaktstellen durch das Einbetten im Klebstoff vor Umwelteinflüssen geschützt. Die Flip-Chip-Montage ist in der DE 10 2004 059 281 B3 und der DE 10 2007 058 802 B3 beschrieben.

Bei Verbindungsprozessen, bei denen Bauelemente mit derartigen mehrschichtigen Folienelementen verbunden werden, z. B. beim Chip-Bonding von Transponder-Chips oder Verdrahtungselementen mit einem darauf montierten Chip auf derartigen mehrschichtigen Folienelementen, insbesondere auf RFID-Antennen in Form mehrschichtiger Folienelemente, hat sich nun gezeigt, dass es beim Einsatz von Substraten aus leicht schmelzbaren Materialien, z. B. PVC-ABS, als Träger für die RFID-Antenne zu Anhaftungen dieser Materialien an einer Thermode kommen kann (PVC = Polyvinylchlorid; ABS = Acrylnitril-Butadien-Styrol-Copolymerisat). Material-Anhaftungen an der Thermode verhindern allerdings einen gleichmäßigen und vollflächigen Kontakt zwischen der Thermode und dem Substrat, was zu Produktionsfehlern führt.

US 2010/147958 A1 beschreibt ein mehrschichtiges Folienelement nach dem Oberbegriff des Anspruchs 1 und betrifft ein Verfahren zum Erzeugen einer Vorrichtung mit einer Transponderantenne, die mit Kontaktflächen verbunden ist. Hierbei wird eine Thermode eingesetzt. Bei einer Ausführungsform wird ein Antennenkabel in Kontakt mit einer dielektrischen Schicht gebracht. Die Rückseite der dielektrischen Schicht kann dann mit einer Thermode kontaktiert werden. Das Antennenkabel wird im Zusammenwirken mit der Thermode durch einen Stempel befestigt.

Die DE 10 2007 004642 A1 betrifft eine flexible Leiterplattenfolie mit zwei Kupferlagen. Bei einer Ausführungsform befindet sich auf der Oberseite eine erste Kupferlage mit elektrischen Kontakten. Auf der Rückseite befindet sich eine zweite Kupferlage, darauf eine Kleberschicht und darauf eine Polyimidschicht, die als Thermoden-Kontaktschicht mit der Oberfläche fungiert.

Die DE 196 47 845 A1 offenbart ein Verfahren zum Herstellen einer Chipkarte. Ein auf einem Modul befindliche Halbleiterchip ist in einer Ausnehmung eines Kabelträgers mechanisch und elektrisch kontaktiert. Diese Ausnehmung weist Anschlussflächen auf, die Bestandteil einer in der Chipkarte angeordneten induktiven Informationsübertragungseinrichtung sind oder zu dieser führen. Der Halbleiterchip kann sich auf einem Trägersubstrat befinden, das an seiner Unterseite Kontaktseiten aufweist, die zu den Anschlussflächen der induktiven lnformationsübertragungseinrichtung führen. Zum stoffschlüssigen Verbinden dieser Kontakte mit den Anschlussflächen wird der Modul mit der Trägersubstratrückseite voran in die Ausnehmung des Kartenkörpers eingesetzt und etwa mittels Thermoden verlötet.

Der Erfindung liegt nun die Aufgabe zugrunde, ein verbessertes mehrschichtiges Folienelement und ein verbessertes Verfahren anzugeben, bei dem bzw. durch das störende Material-Anhaftungen an einer Thermode verhindert werden.

Diese Aufgabe wird von einem mehrschichtigen Folienelement gelöst, das eine dielektrische Schicht, die eine Vorderseite und eine der Vorderseite gegenüberliegende Rückseite aufweist, umfasst, wobei das Folienelement eine ein erstes Bauelement bildende Schicht und mindestens eine auf der Vorderseite angeordnete, mit dem ersten Bauelement verbundene Bauelement-Kontaktfläche zum Anordnen eines zweiten Bauelements aufweist, wobei das Folienelement mindestens eine auf der dielektrischen Schicht angeordnete Thermoden-Kontaktschicht aufweist, die, senkrecht zu der dielektrischen Schicht gesehen, im Bereich der mindestens einen Bauelement-Kontaktfläche angeordnet ist und auf einer von der dielektrischen Schicht abgewandten Seite der mindestens einen Thermoden-Kontaktschicht eine Thermoden-Kontaktfläche, die eine äußere Oberfläche des Folienetements bildet, aufweist. Die das erste Bauelement bildende Schicht ist eine Metallschicht mit einer Dicke von 1 µm bis 50 µm, bevorzugt von 5 µm bis 15 µm. Die Thermoden-Kontaktschicht ist ebenfalls als Metallschicht ausgebildet.

Diese Aufgabe wird weiter durch ein Verfahren zum Befestigen eines zweiten Bauelements auf einem mehrschichtigen Folienelement nach einem der Ansprüche 1 bis 21 gelöst, wobei das Verfahren die Schritte umfasst: Beschichten einer Kontaktflächen aufweisenden Seite des zweiten Bauelements und/oder der mindestens einen Bauelement-Kontaktfläche mit einem thermisch aktivierbaren Verbindungsmittel, vorzugsweise einem thermisch aktivierbaren, insbesondere leitfähigen Klebstoff; Anordnen der die Kontaktflächen aufweisenden Seite des zweiten Bauelements auf der mindestens einen Bauelement-Kontaktfläche; Kontaktieren der mindestens einen Thermoden-Kontaktfläche mit einer Thermode zur Aktivierung des Verbindungsmittels; und Trennen der Thermode von der mindestens einen Thermoden-Kontaktfläche nach der Aktivierung des Verbindungsmittels. Das erfindungsgemäße Verfahren stellt einen Verbindungsprozess, auch Bonding-Prozess genannt, zum Verbinden eines zweiten Bauelements mit einem mehrschichtigen Folienelement dar.

Es ist bevorzugt, wenn das erste Bauelement oder das zweite Bauelement oder beide als elektrische oder elektronische Bauelemente ausgebildet sind. Beispiele für solche elektrischen oder elektronischen Bauelemente sind Antennenstrukturen, Leiterbahnstrukturen, elektronische Mikrochips, kurz "Chip" genannt, Batterien, insbesondere flexible Folienbatterien für die Energieversorgung oder Energiepufferung für einen Chip oder für weitere Bauelemente, Signalausgabeeinrichtungen wie z.B. Lautsprecher, piezoelektrische Elemente, Anzeigeelemente, z.B. Leuchtdioden, Flüssigkristallanzeigen oder weitere signalverarbeitende oder signalaufbereitende Bauelemente, die insbesondere elektrische Signale, die von einer Antennenstruktur empfangen werden, verarbeiten.

In der folgenden Beschreibung ist der Begriff "Chip" so zu verstehen, dass er sowohl einen Chip als solchen als auch ein Verdrahtungselement oder Kontaktierungselement mit einem darauf montierten Chip umfasst. Beispiele für ein solches Verdrahtungselement oder Kontaktierungselement mit einem darauf montierten Chip sind ein sogenannter "Chip-On-Strap" oder ein sogenannter "Adaptive Kernel", bei welchem das Verdrahtungselement oder Kontaktierungselement neben dem Chip noch eine Antenne aufweisen kann. "Montiert" ist dabei als insbesondere mechanisch befestigende und/oder elektrisch leitende und/oder thermisch leitende Verbindung zu verstehen.

"Thermisch aktivierbar" kann bedeuten, dass das Verbindungsmittel durch Einwirkung von Wärme vollständig oder teilweise ausgehärtet wird, d.h. dass es sich um ein thermisch aushärtbares Verbindungsmittel handelt. "Thermisch aktivierbar" kann auch bedeuten, dass neben der Einwirkung von Wärme zusätzlich ein Energieeintrag in das Verbindungsmittel oder ein anders gearteter äußerer Einfluss auf das Verbindungsmittel zum Anstoßen von chemischen Reaktionen in dem Verbindungsmittel erfolgt, insbesondere mittels elektrischer und/oder magnetischer Felder oder mittels sichtbarem oder nicht sichtbarem Licht, UV-Strahlung, IR-Strahlung oder mittels Einwirken von Feuchtigkeit (UV = Ultraviolett; IR = Infrarot). Es ist auch möglich, dass das thermisch aktivierbare Verbindungsmittel ein dualhärtendes Verbindungsmittel ist, d.h. aushärtbar durch eine der folgenden Kombinationen: photoinitiiert + Wärme oder Wärme + Feuchtigkeit.

Die dielektrische Schicht kann aus einer einzigen Schicht bestehen oder mehrere Schichtlagen aufweisen, von denen mindestens eine Lage dielektrische Eigenschaften aufweist. Diese eine oder mehreren Schichten können als eine Folie oder ein Folienlaminat ausgebildet sein. Die dielektrische Schicht bildet ein Substrat, auf dem weitere Schichten, darunter mindestens eine vorzugsweise elektrisch leitfähige Schicht, aufgebracht werden. Auf diese Weise werden auf der dielektrischen Schicht zumindest ein erstes Bauelement, z. B. eine Antennenstruktur, und mindestens eine Bauelement-Kontaktfläche, z. B. eine Chip-Kontaktfläche, ausgebildet. Die dielektrische Schicht weist zwei Seiten auf: eine erste Seite der dielektrischen Schicht bildet die Vorderseite bzw. Frontseite mit der mindestens einen Bauelement-Kontaktfläche, auf der ein zweites Bauelement, vorzugsweise ein Chip, direkt oder indirekt mittels eines Verdrahtungselements, angeordnet wird; die andere, gegenüberliegende Seite der dielektrischen Schicht bildet die Rückseite bzw. Unterseite. Auf der Vorderseite und/oder der Rückseite der dielektrischen Schicht können neben dem ersten Bauelement und dem zweiten Bauelement noch weitere insbesondere elektrische oder elektronische Bauelemente angeordnet sein, die vorzugsweise zusammen mit dem ersten Bauelement und dem zweiten Bauelement eine Funktionseinheit bilden oder davon getrennte elektrische Funktionseinheiten bilden.

Die Begriffe "Vorderseite", "Frontseite", "Rückseite" und "Unterseite" beziehen sich auf eine willkürliche Definition, bei der diejenige Seite der dielektrischen Schicht, auf der mindestens eine Bauelement-Kontaktfläche angeordnet ist und auf der folglich auch ein zweites Bauelement angeordnet wird, als "Vorderseite" bzw. "Frontseite" und die gegenüberliegende Seite der dielektrischen Schicht als "Rückseite" bzw. "Unterseite" bezeichnet wird. Mit dieser Definition sind allerdings keine Beschränkungen hinsichtlich der tatsächlichen Orientierung der dielektrischen Schicht in einem Herstellungsverfahren oder während einer nachfolgenden Verwendung des Folienelements verbunden. Alternativ könnte ebenso der Begriff "erste Seite" bzw. "Bauelementseite" anstatt "Vorderseite", und der Begriff "zweite Seite" anstatt "Rückseite" verwendet werden.

Bei der Angabe "senkrecht zu der dielektrischen Schicht gesehen" wird die dielektrische Schicht als eine annähernd konstant dicke Schicht mit zwei planparallelen Begrenzungsflächen, insbesondere Vorderseite und Rückseite, betrachtet. Eine Ansicht eines Bauteils senkrecht zu der dielektrischen Schicht entspricht in dieser Näherung einer Projektion des Bauteils auf die Vorderseite oder die Rückseite der dielektrischen Schicht, wobei die Projektion senkrecht zu den planparallelen Begrenzungsflächen erfolgt.

Die mindestens eine Thermoden-Kontaktschicht ist ein flächiges, räumlich ausgebildetes Element, umfassend eine der dielektrischen Schicht zugewandte, innere Stirnseite, über die sie mit der dielektrischen Schicht verbunden ist, eine der dielektrischen Schicht abgewandte, äußere Stirnseite, welche die Thermoden-Kontaktfläche bildet, und eine oder mehrere die beiden Stirnseiten verbindende, vorzugsweise im wesentlichen senkrecht zu der dielektrischen Schicht verlaufende Seitenflächen.

Die mindestens eine Thermoden-Kontaktschicht kann, relativ zu der dielektrischen Schicht, in einer gleichen Ebene wie die das erste Bauelement bildende Schicht angeordnet sein oder in einer Ebene, die relativ zu der dielektrischen Schicht über bzw. unter der Ebene der die das erste Bauelement bildenden Schicht liegt, angeordnet sein.

Durch die Erfindung wird vorgeschlagen, das Folienelement mit der mindestens einen Thermoden-Kontaktschicht umfassend die Thermoden-Kontaktfläche auszustatten, wobei die mindestens eine Thermoden-Kontaktschicht, senkrecht zu der dielektrischen Schicht des Folienelements gesehen, im Bereich der mindestens einen Bauelement-Kontaktfläche angeordnet ist. Dabei bildet die Thermoden-Kontaktfläche die äußere Oberfläche des Folienelements, d. h. sie liegt an der Oberfläche des mehrschichtigen Folienelements, und ist daher durch eine von außen an das Folienelement herangeführte Thermode unmittelbar kontaktierbar, d. h. die Thermode kann auf der Thermoden-Kontaktfläche temporär angeordnet und dann wieder von der Thermoden-Kontaktfläche getrennt werden. Die Thermoden-Kontaktfläche wird zur Aktivierung eines thermisch aktivierbaren Verbindungsmittels, das sich zwischen der mindestens einen Bauelement-Kontaktfläche und dem zweiten Bauelement befindet, in direkten Kontakt mit der Thermode gebracht. Wärme wird von der Thermode über die Thermoden-Kontaktschicht bis zu dem Verbindungsmittel übertragen, wo sie zu einer Aktivierung des Verbindungsmittels führt.

Wenn die dielektrische Schicht leicht schmelzbares Material enthält, kann die Wärme der Thermode zu einem Schmelzen dieses Materials (= Substratmaterial) führen. Da die Thermode erfindungsgemäß nicht direkt mit der dielektrischen Schicht in Kontakt steht, sondern an der temperaturbeständigen Thermoden-Kontaktfläche anliegt, wird vermieden, dass beim Trennen der Thermode von der Thermoden-Kontaktfläche geschmolzenes Substratmaterial an der Thermode haften bleibt und es dadurch eventuell zu einer Zerstörung von auf der dielektrischen Schicht angeordneten, vorzugsweise elektrischen Bauelementen, insbesondere von elektrisch leitenden Strukturen wie Antennenstrukturen, oder dergleichen kommt. Auf diese Weise wird durch die vorliegende Erfindung die Produktion von Folienelementen, auf denen mittels Thermoden ein Bauelement, z. B. ein Chip befestigt wird, erheblich verbessert.

Die Thermoden-Kontaktschicht führt auch zu einer Homogenisierung der Temperaturverteilung in dem Substrat während eines Verbindungsprozesses zum Verbinden des zweiten Bauelements mit dem mehrschichtigen Folienelement, z. B. während eines Chip-Bonding-Prozesses. Durch die Homogenisierung der Temperaturverteilung werden lokal erhöhte Temperaturen, d. h. unerwünschte Temperaturspitzen, im Substrat vermieden. Daher kann bei dem erfindungsgemäßen Verfahren die Thermode sogar eine höhere maximale Temperatur als in herkömmlichen Verbindungsprozessen, z. B. herkömmlichen Chip-Bonding-Prozessen, aufweisen (z. B. ist ein Temperaturanstieg um +30 °C möglich), ohne dass es zu einem unerwünschten Aufschmelzen des Trägersubstrats kommt. Die höhere Temperatur der Thermode führt zu höheren Temperaturen im Bereich der Bauelement-Kontaktfläche, so dass die Aktivierungsdauer eines thermisch aktivierbaren Verbindungsmittels, z. B. die Aushärtedauer eines thermisch aushärtbaren leitfähigen Klebstoffs, signifikant reduziert wird. Dadurch sind ein höherer Maschinendurchsatz und eine Reduzierung der Prozesskosten möglich. Darüber fällt durch die höhere Temperatur im Bereich der Bauelement-Kontaktflächen möglicherweise eine Beschränkung auf Spezialklebstoffe, die bei relativ niedrigen Temperaturen aushärten, weg, so dass auch kostengünstigere Klebstoffe und Materialien, die zu ihrer Aktivierung höhere Temperaturen benötigen, verwendet werden können.

Gegenüber einem alternativen Verfahren zur Vermeidung von störenden Material-Anhaftungen, bei der zwischen unterer Thermode und dielektrischer Schicht ein Silikonpapier mitgeführt wird, hat die vorliegende Erfindung den Vorteil, dass keine aufwändige Modifikation an der Produktionsanlage, die das Mitführen des Silikonpapiers erlaubt, vorgenommen werden muss. Durch die Erfindung wird das aufwändige und störanfällige Mitführen von Silikon papier, o. ä. zwischen einer Thermode und der dielektrischen Schicht überflüssig. Es ist in diesem Zusammenhang zu erwähnen, dass es bei den derzeit verfügbaren Chip-Bonding-Maschinen bauartbedingt nur mit hohem Aufwand möglich wäre, zwischen dem Antennensubstrat und einer unteren Thermode ein Silikonpapier o. ä. mitzuführen, um derartige Anhaftungen zu verhindern.

Vorteilhafte Weiterbildungen der Erfindung sind in den Unteransprüchen bezeichnet.

Es ist möglich, dass die das erste Bauelement bildende Schicht eine Metallschicht aus beispielsweise Eisen, Kupfer, Aluminium, Nickel, Silber, Gold, Platin, Zinn, Zink oder einer Legierung dieser Metalle und / oder Mehrschichtsystemen ist. Es ist möglich, dass die das erste Bauelement bildende Schicht eine Antennenstruktur ausbildet, d.h. dass das erste Bauelement eine Antennenstruktur ist. Es ist möglich, dass die mindestens eine Bauelement-Kontaktfläche mit dem ersten Bauelement elektrisch verbunden ist. Es ist möglich, dass die mindestens eine Bauelement-Kontaktfläche eine Chip-Kontaktfläche zum Anordnen eines elektronischen Mikrochips ist.

Es ist möglich, dass das mehrschichtige Folienelement eine dielektrische Schicht umfasst, die eine Vorderseite und eine der Vorderseite gegenüberliegende Rückseite aufweist, wobei das mehrschichtige Folienelement eine eine Antennenstruktur bildende elektrisch leitfähige Schicht und mindestens eine auf der Vorderseite angeordnete, mit der Antennenstruktur elektrisch verbundene Chip-Kontaktfläche aufweist, wobei das Folienelement mindestens eine auf der dielektrischen Schicht angeordnete Thermoden-Kontaktschicht aufweist, die, senkrecht zu der dielektrischen Schicht gesehen, im Bereich der mindestens einen Chip-Kontaktfläche angeordnet ist und auf einer von der dielektrischen Schicht abgewandten Seite der mindestens einen Thermoden-Kontaktschicht eine Thermoden-Kontaktfläche, die eine äußere Oberfläche des Folienelements bildet, aufweist. Dabei ist es bevorzugt, dass das mehrschichtige Folienelement eine RFID-Antenne ausbildet.

Das zweite Bauelement wird auf dem mehrschichtigen Folienelement angeordnet, indem die Kontaktflächen des zweiten Bauelements auf der mindestens einen Bauelement-Kontaktfläche angeordnet werden. Es ist möglich, dass die Kontaktflächen des zweiten Bauelements als thermische Kontakte ausgebildet sind, über die eine thermische Verbindung zwischen dem zweiten Bauelement und dem ersten Bauelement geschaffen wird. Es ist ebenfalls möglich, dass die Kontaktflächen des zweiten Bauelements als elektrische Kontakte, z. B. metallisierte Bereiche, ausgebildet sind, über die eine elektrische Verbindung zwischen dem zweiten Bauelement und dem ersten Bauelement geschaffen wird.

Es ist möglich, dass das Verfahren ein Verfahren zum Befestigen eines Chips auf einem mehrschichtigen Folienelement nach einem der Ansprüche 1 bis 21 ist, wobei bei dem Verfahren eine elektrische Kontakte aufweisende Seite des Chips und/oder der mindestens einen Chip-Kontaktfläche mit einem thermisch aktivierbaren Verbindungsmittel, vorzugsweise einem thermisch aktivierbaren Klebstoff, beschichtet wird, die die elektrischen Kontakte aufweisende Seite des Chips auf der mindestens einen Chip-Kontaktfläche angeordnet wird, zur Aktivierung des Verbindungsmittels die mindestens eine Thermoden-Kontaktfläche mit einer Thermode kontaktiert wird, und nach der Aktivierung des Verbindungsmittels die Thermode von der mindestens einen Thermoden-Kontaktfläche getrennt wird.

Es ist möglich, dass die mindestens eine Thermoden-Kontaktschicht nur auf der Vorderseite der dielektrischen Schicht angeordnet ist, d. h. als eine auf der Vorderseite angeordnete vorderseitige Thermoden-Kontaktschicht, die die mindestens eine Bauelement-Kontaktfläche zumindest bereichsweise umschließt, ausgebildet ist. Dabei ist es bevorzugt, wenn die mindestens eine Thermoden-Kontaktschicht, senkrecht zu der dielektrischen Schicht gesehen, von der mindestens einen Bauelement-Kontaktfläche einen Abstand aufweist. Die Ausführung der vorderseitigen Thermoden-Kontaktschicht ist besonders dann vorteilhaft, wenn eine Vorrichtung für den beschriebenen Verbindungsprozess, z. B. eine Chip-Bonding-Anlage, eine obere Thermode aufweist, die mit der Vorderseite der dielektrischen Schicht in Kontakt kommt. Auf diese Weise kann ein Anhaften von Substratmaterial an der oberen Thermode verhindert werden.

Bei der Verwendung der Begriffe "obere Thermode" und "untere Thermode" handelt es sich um eine willkürliche Definition, bei der eine Thermode, die der Vorderseite der dielektrischen Schicht zugeordnet ist, als "obere Thermode" und eine Thermode, die der Rückseite der dielektrischen Schicht zugeordnet ist, als "untere Thermode" bezeichnet wird. Mit dieser Definition sind allerdings keine Beschränkungen hinsichtlich der tatsächlichen Orientierung einer Thermode in einem Herstellungsverfahren verbunden.

Es ist auch möglich, dass die mindestens eine Thermoden-Kontaktschicht nur auf der Rückseite der dielektrischen Schicht angeordnet ist, d. h. als eine auf der Rückseite angeordnete rückseitige Thermoden-Kontaktschicht, die die mindestens eine Bauelement-Kontaktfläche, senkrecht zu der dielektrischen Schicht gesehen, zumindest bereichsweise überlappt und/oder umschließt, ausgebildet ist. Diese Ausführung ist besonders dann vorteilhaft, wenn eine Vorrichtung für den beschriebenen Verbindungsprozess, z. B. eine Chip-Bonding-Anlage, eine untere Thermode aufweist, die mit der Rückseite der dielektrischen Schicht in Kontakt kommt. Auf diese Weise kann ein Anhaften von Substratmaterial an der unteren Thermode verhindert werden.

Es ist ebenfalls möglich, dass die mindestens eine Thermoden-Kontaktschicht sowohl auf der Vorderseite als auch auf der Rückseite der dielektrischen Schicht angeordnet ist, d. h. als mindestens eine auf der Vorderseite angeordnete vorderseitige Thermoden-Kontaktschicht, die die mindestens eine Bauelement-Kontaktfläche zumindest bereichsweise umschließt, und als mindestens eine auf der Rückseite angeordnete rückseitige Thermoden-Kontaktschicht, die die mindestens eine Bauelement-Kontaktfläche, senkrecht zu der dielektrischen Schicht gesehen, zumindest bereichsweise überlappt und/oder umschließt, ausgebildet ist. Diese Ausführung ist besonders dann vorteilhaft, wenn eine Vorrichtung für den beschriebenen Verbindungsprozess, z. B. eine Chip-Bonding-Anlage, eine obere Thermode aufweist, die mit der Vorderseite der dielektrischen Schicht in Kontakt kommt, und eine untere Thermode aufweist, die mit der Rückseite der dielektrischen Schicht in Kontakt kommt. Durch die Ausbildung mindestens einer vorderseitigen Thermoden-Kontaktfläche und mindestens einer rückseitigen Thermoden-Kontaktfläche kann ein Anhaften von Substratmaterial an der oberen und an der unteren Thermode verhindert werden.

Darüber hinaus können mit der Ausführung der beidseitigen Thermoden-Kontaktfläche die Temperaturverteilung wie auch die Wärmeleitung während des Bond-Prozesses positiv beeinflusst, Prozesszeiten reduziert und Gesamtkosten minimiert werden. Daher kann die Ausbildung einer Thermoden-Kontaktschicht sowohl auf der Vorderseite als auch auf der Rückseite der dielektrischen Schicht auch dann von Vorteil sein, wenn lediglich die untere Thermode auf die Rückseite der dielektrischen Schicht aufgesetzt wird, aber die obere Thermode bzw. ein unbeheizter, als Gegenlager wirkender Druckstempel oder eine vorzugsweise planparallele Platte auf die von dem Folienelement abgewandte Seite (= Oberseite) des zweiten Bauelements, z. B. eines Chips, aufgesetzt wird, d. h. auch wenn eine geringere Gefahr bestünde, dass an der oberen Thermode bzw. dem Druckstempel Substratmaterial anhaftet.

Es hat sich bewährt, wenn die vorderseitige Thermoden-Kontaktschicht die rückseitige Thermoden-Kontaktschicht zumindest bereichsweise überlappt. Auch dadurch kann die Temperaturverteilung, wie auch die Wärmeleitung während des Bond-Prozesses positiv beeinflusst werden.

In bevorzugten Ausführungen sind die auf der Vorder- und der Rückseite angeordneten mindestens zwei Thermoden-Kontaktschichten aus unterschiedlichen Materialien und/oder auch in unterschiedlichen Schichtdicken ausgeformt. Dies kann dann von Vorteil sein, wenn Temperaturgradienten über den Bauelementquerschnitt gewünscht sind.

Es hat sich bewährt, wenn die rückseitige Thermoden-Kontaktschicht die mindestens eine Bauelement-Kontaktfläche, senkrecht zu der dielektrischen Schicht gesehen, vollständig bedeckt oder überdeckt, d. h. dieselbe Größe und dieselbe Form aufweist oder vollständig überragt. Auf diese Weise wird eine im wesentlichen gleichmäßige Erwärmung der Bauelement-Kontaktfläche erreicht, d. h. eine Homogenisierung der Temperaturverteilung im Bereich der Bauelement-Kontaktfläche, insbesondere wenn die Thermoden-Kontaktschicht aus einem gut wärmeleitenden Material ausgebildet ist und/oder die Thermoden-Kontaktschicht im wesentlichen mit ihrer gesamten Thermoden-Kontaktfläche an der Thermode anliegt. Je mehr die rückseitige Thermoden-Kontaktschicht, senkrecht zu der dielektrischen Schicht gesehen, die mindestens eine Bauelement-Kontaktflächen seitlich überragt, desto gleichmäßiger kann die Bauelement-Kontaktfläche temperiert werden.

Es ist auch möglich, dass die mindestens eine vorderseitige Thermoden-Kontaktschicht und die mindestens eine rückseitige Thermoden-Kontaktschicht durch ein wärmeleitendes Bauelement miteinander thermisch gekoppelt sind. Es hat sich bewährt, wenn dieses wärmeleitende Element aus einem relativ flexiblen Material ausgebildet ist, damit der Thermodendruck der Thermode(n), die auf der/n vorderseitigen und/oder rückseitigen Thermoden-Kontaktschicht(en) lastet, durch das wärmeleitende Element nicht ungleichmäßig wird. Es hat sich bewährt, wenn dieses wärmeleitende Element eine Wärmeleitfähigkeit im Bereich von größer als 10 W/(m K) aufweist. Als geeignete Materialien haben sich dabei gut wärmeleitende Metalle sowie mit Nanoröhrchen (z. B. Nanotubes) und/oder Nanopartikeln gefüllte Harzsysteme erwiesen.

Gemäß eines bevorzugten Ausführungsbeispiels der Erfindung ist die mindestens eine Thermoden-Kontaktschicht aus einem wärmeleitenden Material mit einer Wärmeleitfähigkeit im Bereich von größer als 50 W/(m K), insbesondere aus einem oder mehreren der Metalle Kupfer (Cu), Aluminium (Al), Silber (Ag), Gold (Au), Platin (Pt), Nickel (Ni), Zinn (Sn), Zink (Zn) und/oder Legierungen und/oder Schichtsystemen dieser Metalle, ausgebildet. Es hat sich bewährt, die mindestens eine Thermoden-Kontaktschicht als eine Metallschicht auszubilden, die auch aus einer Metalllegierung oder einer Metallmehrschichtlage bestehen kann.

Es ist möglich, dass die mindestens eine Thermoden-Kontaktschicht in Form einer Metallisierung ausgebildet ist. Dabei kann die Metallisierung durch ein Verfahren bereitgestellt worden sein, bei dem in einer auf einem Substrat angeordneten Metallisierungsschicht durch eine Maskenbelichtung und einen nachfolgenden Abtrag (z. B. eine Abätzung) der belichteten oder unbelichteten Bereiche eine musterförmige Keimschicht (ein sogenannter "Seed Layer") in Form der mindestens einen Thermoden-Kontaktfläche erzeugt wird. Es ist auch möglich, dass die musterförmige Keimschicht mittels eines Druckverfahrens unter Einsatz einer leitfähigen Druckfarbe generiert wird. In beiden Fällen kann die musterförmige Keimschicht durch eine galvanische Materialablagerung verstärkt werden, bis die Thermoden-Kontaktschicht eine gewünschte Schichtdicke aufweist.

Die Thermoden-Kontaktfläche kann auch unter Verwendung eines oder mehrerer der folgenden Verfahren bzw. Prozesse hergestellt werden: Galvanische Prozesse, Strukturierung, LDS (= Laser Direct Structuring), Ablation, Kleben, Lamination, Prägen, Druck, Bedampfung (auch über eine Maske), Sprühen.

Es ist auch möglich, dass die mindestens eine Thermoden-Kontaktschicht Nanoröhren, insbesondere Kohlenstoff-Nanoröhren, und/oder Nanopartikel, insbesondere Kohlenstoff-Nanopartikel, und/oder Gemische derselben aufweist.

Es ist bevorzugt, wenn die mindestens eine Thermoden-Kontaktschicht aus einem temperaturstabilen, in einem Temperaturbereich von 25 bis 300 °C, insbesondere von 25 bis 200°C, beständigen Material ausgebildet ist.

Es hat sich außerdem bewährt, wenn die mindestens eine Thermoden-Kontaktfläche einen kreisförmigen oder rechteckförmigen Umriss aufweist. Es ist bevorzugt, wenn die mindestens eine Thermoden-Kontaktfläche als Kreisfläche ausgebildet ist, mit einem Durchmesser im Bereich von 5 bis 20 mm. Es ist weiter bevorzugt, wenn die mindestens Thermoden-Kontaktfläche als Quadrat ausgebildet ist, mit einer Seitenlänge im Bereich von 5 bis 20 mm. Bevorzugt weist die mindestens eine Thermoden-Kontaktfläche eine maximale Ausdehnung im Bereich von 2 bis 50 mm, insbesondere von 5 bis 25 mm, auf. Es ist weiter bevorzugt, wenn die mindestens eine Thermoden-Kontaktfläche in Größe und Form an eine ihr zugeordnete Thermode angepasst ist, z. B. eine sehr ähnliche oder dieselbe Größe und/oder Form wie die Kontaktfläche der Thermode aufweist.

Es ist möglich, dass die mindestens eine Thermoden-Kontaktfläche, in der Ebene der dielektrischen Schicht gemessen, eine maximale Ausdehnung im Bereich von 2 bis 50 mm, insbesondere von 5 bis 25 mm, aufweist.

Es ist möglich, dass die mindestens eine Thermoden-Kontaktschicht eine maximale Schichtdicke im Bereich von 2 bis 50 µm, insbesondere von 6 bis 14 µm, aufweist. Es ist auch möglich, dass die mindestens eine Thermoden-Kontaktschicht, senkrecht zu der dielektrischen Schicht gemessen, eine ungleichmäßige Schichtdicke aufweist. Dabei kann auch vorgesehen sein, Schichtdickengradienten innerhalb der mindestens einen Thermoden-Kontaktschicht auszubilden, um so gezielt Einfluss auf die Wärmeleitfähigkeit zu nehmen.

Es ist möglich, dass die mindestens eine Thermoden-Kontaktschicht, senkrecht zu der dielektrischen Schicht gesehen, zwei oder mehr voneinander isolierte Teilbereiche (= Einzelbereiche) umfasst. Dabei können zumindest zwei der Teilbereiche aus unterschiedlichen Materialien bestehen und/oder in Größe und/oder Form unterschiedlich ausgebildet sein.

Im Fall einer rückseitigen Thermoden-Kontaktschicht ist es bevorzugt, wenn diese Thermoden-Kontaktschicht einen kreisförmigen inneren Bereich ohne Aussparungen und einen an den inneren Bereich anschließenden ringförmigen äußeren Bereich mit Aussparungen aufweist. Dabei können Aussparungen ausgehend vom inneren Bereich radial nach außen und/oder bogenförmig um den inneren Bereich herum verlaufen. Es ist bevorzugt, wenn der kreisförmige innere Bereich einen Außendurchmesser im Bereich von 1 bis 5 mm und der ringförmige äußere Bereich einen Außendurchmesser im Bereich von 5 bis 20 mm aufweist.

Im Fall einer vorderseitigen Thermoden-Kontaktschicht ist es bevorzugt, wenn diese Thermoden-Kontaktschicht als mindestens zwei nicht miteinander verbundene, um den Bonding-Prozess-Bereich, z. B. den Chip-Bond-Bereich, herum laufende und davon beabstandete Kreisflächenabschnitte ausgebildet ist. Es ist hierbei weiter bevorzugt, einen radialen Abstand zwischen diesen Abschnitten im Bereich von 100 µm bis 5 mm, insbesondere von 150 bis 500 µm zu wählen. Weiter bevorzugt weisen die mindestens zwei Thermoden-Kontaktflächenabschnitte eine maximale Ausdehnung im Bereich von 2 bis 50 mm, insbesondere von 5 bis 25 mm, auf.

Es hat sich außerdem bewährt, wenn die das erste Bauelement ausbildende Schicht eine auf der Vorderseite angeordnete erste Schicht, eine auf der Rückseite angeordnete zweite Schicht und eine oder mehrere die dielektrische Schicht durchdringende Durchkontaktierungen, mittels der die erste Schicht und die zweite Schicht miteinander elektrisch oder thermisch leitend verbunden sind, aufweist, wobei die mindestens eine Thermoden-Kontaktschicht und die eine oder mehreren Durchkontaktierungen, senkrecht zu der dielektrischen Schicht gesehen, ohne gegenseitige Überlappung angeordnet sind. "Ohne gegenseitige Überlappung" bedeutet, dass die eine oder mehreren Durchkontaktierungen entweder unmittelbar an die Thermoden-Kontaktschicht angrenzen oder davon beabstandet sind. Vorzugsweise weisen die mindestens eine Thermoden-Kontaktschicht und die eine oder mehreren Durchkontaktierungen, senkrecht zu der dielektrischen Schicht gesehen, einen Abstand von mindestens 200 µm auf.

Es ist möglich, dass das erste Bauelement einen zweiseitigen Aufbau aufweist mit einer auf der Vorderseite der dielektrischen Schicht angeordneten ersten Schicht (= erster Teil des ersten Bauelements) und einer auf der Rückseite der dielektrischen Schicht angeordneten zweiten Schicht (= zweiter Teil des ersten Bauelements). Auf der Vorderseite der dielektrischen Schicht kann eine erste elektrisch leitfähige Schicht, z. B. ein erster Leiterbahnabschnitt wie ein Antennenabschnitt, auf der Rückseite der dielektrischen Schicht eine zweite elektrisch leitfähige Schicht, z. B. ein zweiter Leiterbahnabschnitt wie ein Antennenabschnitt, oder auch nur ein Verbindungsabschnitt für zwei Enden des vorderseitigen Leiterbahnabschnittes angeordnet sein. Vorzugsweise sind der erste und der zweite Leiterbahnabschnitt spulenförmig in Form von einer oder mehreren Windungen ausgeformt. Die ein oder mehreren Durchkontaktierungen zwischen der Vorderseite und der Rückseite der dielektrischen Schicht verbinden beim zweiseitigen Aufbau des ersten Bauelements die erste Schicht, z. B. den ersten Leiterbahnabschnitt, und die zweite Schicht, z. B. den zweiten Leiterbahnabschnitt, elektrisch miteinander.

Eine Durchkontaktierung umfasst je eine Kontaktstelle an der Vorderseite und der Rückseite sowie ein durch die dielektrische Schicht verlaufendes Verbindungselement, das die beiden Kontaktstellen elektrisch verbindet. Es ist bevorzugt, wenn die mindestens eine Thermoden-Kontaktschicht, senkrecht zu der dielektrischen Schicht gesehen, weder die Kontaktstellen noch die Verbindungselemente der einen oder mehr Durchkontaktierungen überragt. Durch die Positionierung der Durchkontaktierungen außerhalb des Bereiches der Thermoden-Kontaktschicht und damit außerhalb des Bereiches der Thermode wird ein ungleichmäßiger Thermodendruck vermieden. In diesem Zusammenhang ist zu erwähnen, dass dadurch auch vermieden wird, dass zusätzliche Druckkräfte auf die Durchkontaktierungen ausgeübt und diese womöglich zerstört werden.

Weiter ist es möglich, dass die mindestens eine Thermoden-Kontaktfläche, senkrecht zu der dielektrischen Schicht gesehen, eine oder mehrere die mindestens eine Thermoden-Kontaktschicht vollständig durchdringende Aussparungen, z. B. Löcher, Ausstanzungen, Perforationen, aufweist. Dabei ist es möglich, dass die eine oder mehreren Aussparungen und/oder die die Aussparungen umgebende Thermoden-Kontaktfläche eine optische Information bereitstellen, z. B. ein alphanumerisches Zeichen, ein Symbol, eine Grafik, ein Muster. Beispiele solcher Muster sind beispielsweise konzentrisch verlaufende Kreisringe, strahlenförmige Segmente, Wellenstrukturen, Parallelstreifen, Karo-Strukturen, etc. oder Kombinationen davon. Auf diese Weise kann durch die mindestens eine Thermoden-Kontaktschicht ein Sicherheitselement, ein dekoratives Element oder eine Kennzeichnung bereitgestellt werden. Es ist auch möglich, dass die mindestens eine Thermoden-Kontaktschicht zumindest teilweise eingefärbt ist und/oder eine Eigenfärbung aufweist, was ebenfalls als ein Sicherheitsmerkmal oder zur Kontrastverbesserung für optische Erkennungssysteme oder als Dekor genutzt werden kann. Es ist möglich, dass zunächst eine vollflächige Thermoden-Kontaktschicht hergestellt wird und die Aussparungen nachträglich in der vollflächigen Thermoden-Kontaktschicht ausgebildet werden, z. B. durch Laserablation. Es ist auch möglich, dass die Aussparungen in allen Fertigungsstufen der Thermoden-Kontaktschicht vorhanden sind. Es ist bevorzugt, dass das Flächenverhältnis der einen oder mehreren Aussparungen zu der Thermoden-Kontaktfläche im Bereich von 5:1 bis 1:5 liegt.

Aussparungen in der Thermoden-Kontaktfläche können es ermöglichen, dass eine oberhalb der Thermoden-Kontaktfläche angeordnete Schicht und eine unterhalb der Thermoden-Kontaktfläche angeordnete Schicht durch die Aussparungen hindurch aneinander haften, so dass eine mechanische Verbindung der beiden Schichten, die sogenannte Zwischenschichthaftung, im Bereich der Thermoden-Kontaktschicht verbessert wird. Die Zwischenschichthaftung zwischen einer oberhalb der Thermoden-Kontaktfläche angeordneten Schicht, z. B. einer Deckschicht, und einer unterhalb der Thermoden-Kontaktfläche angeordneten Schicht, z. B. einer dielektrische Schicht, ist insbesondere bei einer Kartenlamination, d. h. bei einer Auftragung einer die Thermoden-Kontaktschicht überdeckenden Schicht auf das Antennensubstrat, von Bedeutung.

Gemäß eines bevorzugten Ausführungsbeispiels der Erfindung weist die mindestens eine Thermoden-Kontaktfläche ein Oberflächenrelief, z. B. eine Rasterung, ein Linienraster, eine Beugungsstruktur, auf. Es ist möglich, dass zur Ausbildung des Oberflächenreliefs ein Prägestempel in die noch verformbare mindestens eine Thermoden-Kontaktschicht eingepresst wird, so dass sich mindestens eine Thermoden-Kontaktfläche mit einem Oberflächenrelief ausbildet. Dabei ist es möglich, dass das Oberflächenrelief einen optischen Effekt, z. B. einen Beugungseffekt, hervorruft. Auf diese Weise kann durch die mindestens eine Thermoden-Kontaktschicht ein Sicherheitselement oder ein dekoratives Element bereitgestellt werden.

Es ist möglich, dass die mindestens eine Thermoden-Kontaktschicht mit der das erste Bauelement bildenden Schicht und/oder der mindestens einen Bauelement-Kontaktfläche elektrisch leitend verbunden ist oder von der das erste Bauelement bildenden Schicht und/oder der mindestens einen Bauelement-Kontaktfläche elektrisch isoliert ist.

Dabei kann vorgesehen sein, dass die mindestens eine Thermoden-Kontaktschicht vor dem Bonding-Prozess, z. B. dem Chip-Bond-Prozess, mit dem ersten Bauelement, z. B. einem oder mehreren Leiterbahnabschnitten wie einer Antenne, und/oder der mindestens einen Bauelement-Kontaktfläche elektrisch leitend verbunden ist, jedoch nach dem Bond-Prozess davon separat, d. h. elektrisch isoliert, angeordnet ist.

In diesem Zusammenhang kann vorgesehen sein, dass das erfindungsgemäße Verfahren ferner den folgenden Schritt umfasst: Durchtrennen einer elektrisch leitenden Verbindung zwischen der mindestens einen Thermoden-Kontaktschicht und der das erste Bauelement bildenden Schicht und/oder der mindestens einen Bauelement-Kontaktfläche. Dies kann z. B. durch ein thermisches oder auch mechanisches Durchtrennen von vorzugsweise dünnen Kontaktbrücken während des Bonding-Prozesses erreicht werden. Dazu kann die Thermode Schneidkontakte aufweisen oder durch die thermische Energie der Thermode kann eine Kontaktbrücke aufgeschmolzen oder anderweitig thermisch zerstört werden. Auch der Einsatz eines Lasers zum Durchtrennen der Kontaktbrücke ist möglich.

Eine elektrische Isolierung während des Herstellungsprozesses kann auch in der folgenden Weise vorteilhaft sein: Während der Herstellung des Folienelements ist die Thermoden-Kontaktschicht mit einem ersten Bauelement, z. B. einem oder mehreren Leiterbahnabschnitten, und/oder einer oder mehreren Bauelement-Kontaktflächen und/oder einer oder mehreren elektrischen Kontaktstellen des mehrschichtigen Folienelements elektrisch leitend verbunden, um dabei eine verbesserte Erzeugung homogener Schichtdicken durch eine Galvanisierung, d. h. mittels eines galvanischen Schichtaufbaus, zu erreichen, insbesondere zur Verbesserung eines galvanischen Verfahrens zur galvanischen Schichtverstärkung elektrisch leitfähiger Strukturen des Folienelements. Nach dem Bond-Prozess kann dagegen eine elektrisch isolierte Thermoden-Kontaktschicht vorteilhaft sein, z. B. um elektromagnetische Störeffekte durch die leitfähige Fläche der Thermoden-Kontaktschicht in Verbindung mit einem Bauelement, insbesondere einer Antenne, zu vermeiden. Ferner ist es auch möglich, dass in einem anschließenden Prozess, z. B. mittels einer Laserablation, an der Thermoden-Kontaktschicht eine Feinanpassung der Frequenz über die Kapazität erfolgt.

Es ist auch möglich, dass die mindestens eine Thermoden-Kontaktschicht einen Teil eines elektrischen Bauelements des Folienelements bildet. Dabei kann auch vorgesehen sein, dass die mindestens eine Thermoden-Kontaktschicht vor dem Bond-Vorgang ein Teil des elektrischen Bauelementes ist, wobei dieser Teil jedoch nach dem Bond-Vorgang abgekoppelt wird und dadurch elektrisch unwirksam wird, z. B. durch Abtrennung zur restlichen Leiterbahn. Es hat sich weiter bewährt, dass die mindestens eine Thermoden-Kontaktschicht einen Teil eines elektrischen Bauelements des Folienelements bildet. So ist es in diesem Zusammenhang möglich, dass die mindestens eine Thermoden-Kontaktschicht einen Teil einer Kondensatorfläche, eines Widerstandes oder dergleichen darstellt, wodurch die Funktion und Performance des Bauelementes beeinflusst werden kann. Auch ist es vorstellbar, dass die Thermoden-Kontaktschicht selber in Form einer Spule oder Spulenelementes mit vorgegebener Induktivität ausgebildet ist, die in Reihe oder auch parallel zum restlichen Bauelement geschaltet werden kann.

Es ist auch möglich, dass die mindestens eine Thermoden-Kontaktschicht aus einem bezüglich Wärmeleitfähigkeit anisotropen Material ausgebildet ist. Dabei ist es möglich, dass innerhalb der Thermoden-Kontaktschicht die Wärmeleitung bevorzugt in einer Richtung erfolgt. Dies kann zum Einen beispielsweise so bewerkstelligt werden, dass die Thermoden-Kontaktschicht aus parallelen Strukturen, die aus wärmeleitfähigem Material aufgebaut sind, ausgebildet ist. Bei einem Wärmeeintrag auf einer Außenseite der Thermoden-Kontaktschicht kommt es bevorzugt zu einer schnelleren Wärmeleitung in Richtung dieser parallelen Strukturen, hingegen zu einer verminderten Wärmeleitung in einer senkrechten Richtung dazu. Zum Anderen kann aber auch durch eine Variation der Schichtdicke des wärmeleitfähigen Materials gezielt Einfluss auf die Wärmeleitung genommen werden.

Es ist auch möglich, dass die Thermoden-Kontaktschicht nach dem Bonding-Prozess in einem oder mehreren darauf folgenden Prozessschritten teilweise oder vollständig wieder von der dielektrischen Schicht entfernt wird.

Im Weiteren wird die Erfindung anhand von mehreren Ausführungsbeispielen unter Bezugnahme auf die folgenden Zeichnungen beispielhaft erläutert. Die Zeichnungen sind zur Vereinfachung der Darstellung nur schematisch und nicht maßstabsgetreu. Es zeigt:
- Fig. 1: eine auf einer Vorderseite einer dielektrischen Schicht angeordnete erste elektrisch leitfähige Schicht;
- Fig. 2: eine zweite elektrisch leitfähige Schicht und eine Thermoden-Kontaktschicht, die zusammen auf einer Rückseite einer dielektrischen Schicht angeordnet sind;
- Fig. 2A: eine vergrößerte Ansicht der rückseitigen Thermoden-Kontaktschicht nach Fig. 2;
- Fig. 3: eine Überlagerung der Schichten nach Fig. 1 und Fig. 2;
- Fig. 4: einen Schnitt IV-IV der in Fig. 3 gezeigten Schichten;
- Fig. 5: den Schnitt IV-IV, wie in Fig. 4 gezeigt, zusätzlich mit einer Darstellung eines Chips und zweier Thermoden;
- Fig. 6, 9, 12, 15 und 18: jeweils die erste elektrisch leitfähige Schicht gemäß Fig. 1;
- Fig. 7, 10, 13, 16 und 19: jeweils die zweite elektrisch leitfähige Schicht gemäß Fig. 2 zusammen mit je einem unterschiedlichen weiteren Ausführungsbeispiel der Thermoden-Kontaktschicht;
- Fig. 7A, 10A, 13A, 16A und 19A: jeweils eine vergrößerte Ansicht der rückseitigen Thermoden-Kontaktschicht nach den Fig. 7, 10, 13, 16 und 19;
- Fig. 8, 11, 14, 17 und 20: jeweils eine Überlagerung der ersten elektrisch leitfähigen Schicht nach Fig. 1 (entsprechend den Fig. 6, 9, 12, 15 und 18) mit der zweiten elektrisch leitfähigen Schicht und der Thermoden-Kontaktschicht nach den Fig. 7, 10, 13, 16 und 19;
- Fig. 21: eine weitere Ausführungsform einer auf einer Vorderseite einer dielektrischen Schicht angeordneten ersten elektrisch leitfähigen Schicht mit innen liegendem Chip-Bond-Bereich;
- Fig. 22: eine zweite elektrisch leitfähige Schicht in Form eines Kontaktierungsbereiches und eine Thermoden-Kontaktschicht, die zusammen auf einer Rückseite einer dielektrischen Schicht angeordnet sind;
- Fig. 23: eine Überlagerung der Schichten nach Fig. 21 und Fig. 22;
- Fig. 24: eine weitere Ausführungsform einer auf einer Vorderseite einer dielektrischen Schicht angeordneten ersten elektrisch leitfähigen Schicht;
- Fig. 25: eine zweite elektrisch leitfähige Schicht in Form eines Kontaktierungsbereiches und eine Thermoden-Kontaktschicht, die zusammen auf einer Rückseite einer dielektrischen Schicht angeordnet sind;
- Fig. 26: eine Überlagerung der Schichten nach Fig. 24 und Fig. 25;
- Fig. 27: eine weitere Ausführungsform einer auf einer Rückseite einer dielektrischen Schicht angeordneten zweiten elektrisch leitfähigen Schicht mit implementierter Thermoden-Kontaktfläche;
- Fig. 28: eine erste elektrisch leitfähige Schicht in Form eines Bond-Pads und Kontaktierungsbereiches, die zusammen auf einer Vorderseite einer dielektrischen Schicht angeordnet sind;
- Fig. 29: eine Überlagerung der Schichten nach Fig. 27 und Fig. 28;
- Fig. 30: eine weitere Ausführungsform einer auf einer Vorderseite einer dielektrischen Schicht angeordneten ersten elektrisch leitfähigen Schicht mit implementierter frontseitiger Thermoden-Kontaktfläche, die aus Thermoden-Kontaktflächenbereichen besteht, und einem Chip-Bond-Bereich;
- Fig. 31: die zweite elektrisch leitfähige Schicht gemäß Fig. 25; und
- Fig. 32: eine Überlagerung der Schichten nach Fig. 30 und Fig. 31.

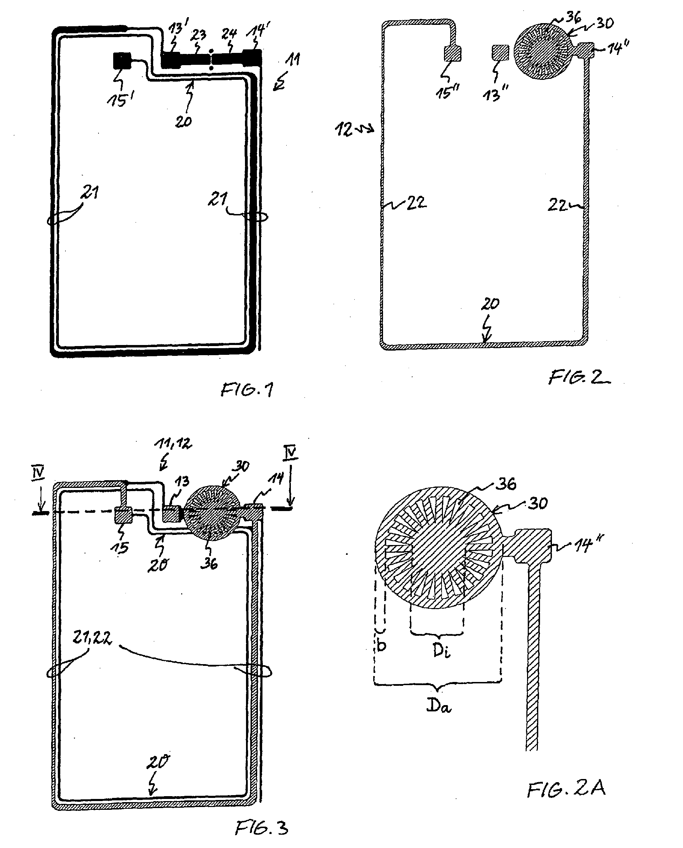

Fig. 1 zeigt eine auf einer Vorderseite einer dielektrischen Schicht angeordnete erste ein erstes Bauelement ausbildende Schicht, die als eine erste elektrisch leitfähige Schicht 11 ausgebildet ist. Die erste elektrisch leitfähige Schicht 11 bildet zwei Chip-Kontaktflächen 23 und 24 aus, wobei die erste Chip-Kontaktfläche 23 mit einer vorderseitigen Kontaktierungsfläche 13' für eine erste Durchkontaktierung 13 und über einen spulen- bzw. spiralförmigen Leiterbahnabschnitt 21 einer Leiterbahn 20 mit einer vorderseitigen Kontaktierungsfläche 15' für eine dritte Durchkontaktierung 15 verbunden ist. Die zweite Chip-Kontaktfläche 24 ist mittels einer vorderseitigen Kontaktierungsfläche 14' für eine zweite Durchkontaktierung 14 mit einem linearen Reststück des spulen- bzw. spiralförmigen Leiterbahnabschnitts 21 verbunden.

Fig. 2 zeigt eine zweite das erste Bauelement ausbildende Schicht, die als eine zweite elektrisch leitfähige Schicht 12 ausgebildet ist, und eine Thermoden-Kontaktschicht 30, die zusammen auf einer Rückseite der dielektrischen Schicht angeordnet sind. Die zweite elektrisch leitfähige Schicht 12 weist einen bogenförmigen Leiterbahnabschnitt 22 der Leiterbahn 20 auf, der eine rückseitige Kontaktierungsfläche 15" für die dritte Durchkontaktierung 15 mit einer rückseitigen Kontaktierungsfläche 14" für die zweite Durchkontaktierung 14 verbindet. Darüber hinaus umfasst die zweite elektrisch leitfähige Schicht 12 eine rückseitige Kontaktierungsfläche 13" für die erste Durchkontaktierung 13 sowie ein elektrisches Verbindungselement, das die rückseitige Kontaktierungsfläche 14" mit der Thermoden-Kontaktschicht 30 verbindet.

Wie in Fig. 2A vergrößert dargestellt, weist die Thermoden-Kontaktschicht 30 unterschiedlich ausgebildete Teilbereiche auf und hat die Form eines Speichenrads einer Dicke d, bestehend aus einer inneren Scheibe ("Nabe") mit einem Durchmesser Di, einem äußeren Ring ("Felge") mit einem Außendurchmesser Da, einer Wandstärke b und einer Höhe d, sowie einem die innere Scheibe und den äußeren Ring verbindenden ringförmigen Bereich ("Speichenkranz"), der k (in diesem Ausführungsbeispiel ist k = 24) radial verlaufende, rechteckförmige Elemente mit jeweils einer Länge von 1/2 (Da - Di - 2b), einer Breite von πDi/k und einer Höhe d aufweist.

Alternativ kann die Thermoden-Kontaktschicht 30 als eine kreisrunde Scheibe mit einer Dicke d und einem Außendurchmesser Da beschrieben werden, die in einem hohlzylinderförmigen Bereich mit einem Innendurchmesser Di und einem Außendurchmesser Da - 2b insgesamt k (in diesem Ausführungsbeispiel ist k = 24) keilförmige, gleichmäßig radial angeordnete Aussparungen 36 aufweist, wobei die Spitzkanten der Keile zu der Scheibenachse hin orientiert sind und parallel zu der Scheibenachse verlaufen. In Spalte 2 der Tabelle sind typische Werte und besonders vorteilhafte Werte (in der Tabelle mit "bevorzugt" gekennzeichnet) der Schichtdicke d, des Außendurchmessers Da, des Innendurchmessers Di und der Breite b für das vorliegende Ausführungsbeispiel der Thermoden-Kontaktschicht 30 angegeben.

Fig. 3 zeigt eine überlagerte Projektion der Schichten nach Fig. 1 und Fig. 2, senkrecht zu der dielektrischen Schicht gesehen, aus der die korrespondierende Ausgestaltung eines Teils der Leiterbahnabschnitte 21 und 22 der Leiterbahn 20 sowie die, senkrecht zu der dielektrischen Schicht gesehen, deckungsgleiche Anordnung der vorder- und rückseitigen Kontaktierungsflächen 13' bis 15' und 13" bis 15" der Durchkontaktierungen 13 bis 15 erkennbar ist. Die Leiterbahn 20 bildet hierbei eine spiralförmige Antennenstruktur aus. In Fig. 3 ist erkennbar, dass die Thermoden-Kontaktschicht 30, senkrecht zu der dielektrischen Schicht gesehen, die Chip-Kontaktflächen 23, 24 vollständig überdeckt. Die Leiterbahnabschnitte 21, 22 sind in Fig. 3 und in den folgenden Figuren mit geringfügig unterschiedlicher Breite dargestellt, um zeichnerisch die Überlappung der beiden Leiterbahnabschnitte 21, 22 besser erkennbar zu machen. Die Breite der Leiterbahnabschnitte 21, 22 soll aber nicht auf diese Ausführungsform beschränkt sein, d. h. die Leiterbahnabschnitte 21, 22 können eine identische Breite oder eine von einander verschiedene Breite aufweisen und im Wesentlichen vollständig oder auch nur teilweise überlappen. In diesem Zusammenhang sei auch darauf hingewiesen, dass auch die LeiterbahnAbschnitte 21, 22 in Fig. 3 und in den folgenden Figuren zur Vereinfachung der Darstellung als gerade Linien gezeichnet sind. Die gesamten Formen sollen aber nicht auf diese Ausgestaltung beschränkt sein. Es ist ebenso möglich, dass diese Leiterbahnabschnitte als Zick-Zack-Verlauf, als kontinuierlich geschwungener Verlauf, z. B. in Form einer Sinuskurve, oder als eine Form, die sich aus Kombinationen dieser bilden, oder auch anderweitig ausgestaltet sind. Ferner können die verschiedenen Abschnitte der Leitbahnen - bezogen auf die Front-und Rückseite - gleich oder auch zueinander versetzt angeordnet sein.

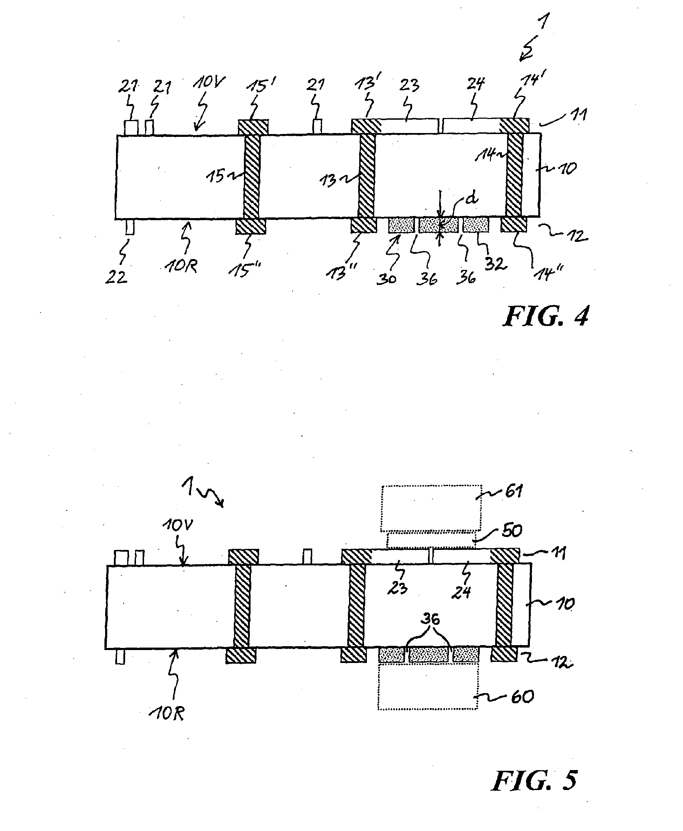

Fig. 4 zeigt einen nicht maßstabsgetreuen, schematischen Schnitt eines mehrschichtigen Folienelements 1, das eine dielektrische Schicht 10, eine auf der Vorderseite 10V der dielektrischen Schicht 10 angeordnete erste elektrisch leitfähige Schicht 11 nach Fig. 1 und eine auf der Rückseite 10R der dielektrischen Schicht 10 angeordnete zweite elektrisch leitfähige Schicht 12 nach Fig. 2 aufweist. Der Schnitt des Folienelements 1 verläuft entlang der in Fig. 3 angegebenen Schnittlinie IV-IV. Die erste elektrisch leitfähige Schicht 11 und die zweite elektrische leitfähige Schicht 12 sind, wie in Fig. 4 verdeutlicht, auf der äußeren Oberfläche der dielektrischen Schicht 10 vorgesehen. In dem Schnitt sind die die dielektrische Schicht 10 durchdringenden Durchkontaktierungen 13 bis 15 mit den entsprechenden vorder- und rückseitigen Kontaktierungsflächen 13' bis 15' und 13" bis 15" zur besseren Unterscheidbarkeit schraffiert dargestellt. Auf der Rückseite 10R der dielektrischen Schicht 10 ist die eine Schichtdicke d und auf der äußeren Stirnseite eine Thermoden-Kontaktfläche 32 aufweisende Thermoden-Kontaktschicht 30 angeordnet, die Aussparungen 36 aufweist, welche durch die gesamte Schichtdicke d hindurch verlaufen.

Fig. 5 zeigt einen nicht maßstabsgetreuen, schematischen Schnitt des mehrschichtigen Folienelements 1, der im Wesentlichen der in Fig. 4 dargestellten Schnittzeichnung entspricht. Zusätzlich sind in Fig. 5 ein Chip 50 und zwei sich gegenüberliegende Thermoden 60 und 61 in einer Position dargestellt, in der sie in einem Verfahren zum Befestigen des Chips 50 auf dem mehrschichtigen Folienelement 1 angeordnet werden. Die untere Thermode 60 beaufschlagt dabei die rückseitige Thermoden-Kontaktschicht 30, und die obere Thermode 61, die als beheizter oder unbeheizter Druckstempel ausgeführt sein kann, bildet ein mechanisches Gegenlager für die untere Thermode 60 und beaufschlagt den Chip 50. Zwischen dem Chip 50 und der Thermode 61 kann ein nicht dargestelltes Zwischenband angeordnet sein, welches beispielsweise silikonbeschichtet oder anderweitig mit einer haftungsvermindernden Beschichtung versehen ist, um ein Verschmutzen oder eine Kontamination der Thermode 61 mit einem Verbindungsmittel und damit auch ein Verkleben der Thermode 61 mit dem Chip 50 zu verhindern. Um die Darstellung zu vereinfachen, wurde darauf verzichtet, alle Bauteile mit ihren Bezugszeichen zu beschriften; diesbezüglich wird auf die in der Fig. 4 angegebenen entsprechenden Bezugszeichen verwiesen. Die von der dielektrischen Schicht 10 abgewandte Stirnseite 32 der Thermoden-Kontaktschicht 30 hat als Thermoden-Kontaktfläche die Funktion, einer (unteren) Thermode 60 als Kontaktfläche zu dienen, wie in Fig. 5 angedeutet ist.

Vorzugsweise ist sowohl die obere Thermode 61 als auch die untere Thermode 60 beheizt, etwa auf eine Temperatur im Bereich von 200 °C. Üblicherweise ist die Temperatur der oberen Thermode 61, d. h. der Thermode auf der Chipseite des Folienelements 1, höher als die der unteren Thermode 60. Durch die Temperaturspreizung können spezielle Aushärteeffekte beim Verbindungsmittel erzielt werden. Durch die von der unteren Thermode 60 an die Thermoden-Kontaktschicht 30 abgegebene und durch die dielektrische Schicht 10 zu den Chip-Kontaktflächen 23, 24 geleitete Wärme kann ein Verbindungsmittel, das zwischen dem Chip 50 und den Chip-Kontaktflächen 23, 24 aufgebracht ist, thermisch aktiviert werden. Durch die thermische Aktivierung des Verbindungsmittel ergibt sich eine dauerhafte mechanische Verbindung zwischen dem Chip 50 und den Chip-Kontaktflächen 23, 24, und damit zwischen dem Chip 50 und dem mehrschichtigen Folienelement 1. Die Stirnfläche des Chips 50 ist kleiner als die plane Stirnseite der oberen Thermode 61 und optional auch kleiner als die plane Stirnseite der unteren Thermode 60, damit die Thermoden 60, 61 auch um den Chip 50 herum ein zwischen dem Chip 50 und den Chip-Kontaktflächen 23, 24 eventuell austretendes Verbindungsmittel zuverlässig aushärten.

Als Verbindungsmittel kann ein thermisch aktivierbarer, z. B. thermisch härtbarer, Klebstoff oder ein Lot verwendet werden. Das Verbindungsmittel kann vor dem Aufsetzen des Chips 50 auf die Chip-Kontaktflächen 23, 24 auf die den Chip-Kontaktflächen 23, 24 zugewandte Seite des Chips 50 und/oder auf die dem Chip 50 zugewandte Seite der Chip-Kontaktflächen 23, 24 aufgebracht werden. Bei dem thermisch aushärtbaren Klebstoff kann es sich beispielsweise um einen warmhärtenden, elektrisch leitfähigen, 1-komponentigen Epoxidkleber mit metallisierten, vorzugsweise sphärischen, nicht flachen Partikeln oder Vollmetallpartikeln, z. B. metallisierte Balls, Flakes oder Platelets, handeln, der in einem Temperaturbereich um ca. 190 °C in ca. 8 Sekunden aushärtet. Vorteilhaft sind in diesem Zusammenhang beispielsweise Metallpartikel aus Silber oder Kupfer, die in die Kunststoffmatrix eingebettet sind. Darüber hinaus können aber auch Systeme eingesetzt werden, deren Partikel aus Graphit gebildet sind und/oder andere Binderkomponenten besitzen, die wiederum Ein- oder Mehrkomponenten-Systeme bilden. Als Lot kann beispielsweise Blei, Zinn oder Palladium verwendet werden.

Bei der dielektrischen Schicht 10 handelt es sich um eine Kunststofffolie einer Dicke von 4 bis 250 µm, die als Trägersubstrat für die erste elektrisch leitfähige Schicht 11 und die zweite elektrisch leitfähige Schicht 12 dient. Vorzugsweise wird als dielektrische Schicht 10 eine Folie aus PVC, PVC/ABS, PET, Polycarbonat, Polyolefinen, Polypropylen, Polystyrol, Polyethylen oder aus BOPP mit einer Dicke von 36 bis 150 µm verwendet (PET = Polyethylenterephthalat; BOPP = biaxially oriented polypropylene). Weiter ist es auch möglich, dass die dielektrische Schicht 10 noch ein oder mehrere weitere Schichten umfasst und/oder neben der dielektrischen Schicht 10 noch ein oder mehrere weitere Schichten zwischen der ersten elektrisch leitfähigen Schicht 11 und der zweiten elektrisch leitfähigen Schicht 12 vorgesehen sind und/oder aus anderen oben nicht aufgeführten nicht leitfähigen Materialien, z. B. einem Papierverbund, besteht.

Bei der elektrisch leitfähigen Schicht bzw. der ersten und zweiten elektrisch leitfähigen Schicht 11, 12 handelt es sich vorzugsweise jeweils um eine metallische Schicht mit einer Dicke von 1 µm bis 50 µm, bevorzugt von 5 bis 15 µm. Die Metallschicht besteht beispielsweise aus Eisen, Kupfer, Aluminium, Nickel, Silber, Gold, Platin, Zinn, Zink oder einer Legierung dieser Metalle und/oder Mehrschichtsystemen. Weiter ist es auch möglich, dass die elektrisch leitfähigen Schichten 11 und 12 mittels mindestens einer galvanischen Verstärkung erzeugt werden und so noch ein oder mehrere leitfähige Schichten, beispielsweise bestehend aus einem leitfähigen Druckstoff, umfassen können. In diesem Zusammenhang sind auch Kombinationen verschiedener Techniken zur Erzeugung der metallischen Schichten möglich - beispielsweise galvanische Verstärkung in Kombination mit gezielter Demetallisierung.

Die Durchkontaktierungen 13, 14 und 15 bestehen vorzugsweise ebenfalls aus einem in entsprechende Ausnehmungen der dielektrischen Schicht 10 eingebrachten elektrisch leitfähigen, insbesondere metallischen Material und werden vorzugsweise mittels mindestens einem galvanischen Prozess gemeinsam mit den elektrisch leitfähigen Schichten 11 und 12 erzeugt. Es ist aber auch möglich, die Durchkontaktierungen durch Niet-, Crimpverfahren, Lötverfahren und dergleichen zu erzeugen.

Der Leiterbahnabschnitt 21 besitzt - wie in Fig. 1 angedeutet - die Form einer Flachspule mit N Windungen, mit einer Beabstandung der Windungen von 0,05 bis 5 mm und einer Leiterbahnbreite von 0,05 bis 5 mm. Die Windungszahl N liegt vorzugsweise im Bereich von 2 bis 10. Die äußerste Windung umschließt vorzugsweise eine rechteckförmige Fläche einer Breite von 40 mm bis 100 mm und einer Länge von 20 mm bis 80 mm. Der Leiterbahnabschnitt 22 besitzt vorzugsweise eine Länge von mehr als 1/4 der innersten Windung des Leiterbahnabschnitts 21 und ist - wie in Fig. 2 angedeutet - vorzugsweise in Form einer halben bis einer Windung ausgeformt.

Es ist weiter auch möglich, dass das Folienelement 1 neben den anhand der Figuren Fig. 1 bis Fig. 4 erläuterten Schichten über eine oder mehrere weitere Schichten verfügt und beispielsweise eine Laminierfolie, eine Transferfolie oder einen Bereich einer Übertragungslage einer Transferfolie bildet. Weiter ist es auch möglich, dass das Folienelement 1 nicht in vereinzelter Form vorliegt, sondern Teil einer Folienbahn ist, welche bevorzugt eine Vielzahl nebeneinander angeordneter, gleichartiger Folienelemente 1 aufweist.

Die Thermoden-Kontaktschicht 30 kann in demselben Verfahren wie die elektrisch leitfähigen Schichten 11, 12 erzeugt werden. Dabei kann die elektrisch leitfähige Thermoden-Kontaktschicht 30 als eine Metallisierung ausgebildet sein, beispielsweise aus Aluminium, Eisen, Kupfer, Nickel, Platin, Silber, Gold, Zinn, Zink oder einer Legierung dieser Materialien. Zudem kann die Thermoden-Kontaktschicht 30 in diesem Fall zusätzlich eine Funktion als elektromagnetisches Bauelement erfüllen. Weiter ist es auch möglich, dass die Thermoden-Kontaktschicht 30 erst nach der Ausbildung der elektrisch leitfähigen Schichten 11, 12 auf das dielektrische Substrat 10 appliziert wird, z. B. als fertiges Bauelement temporär oder dauerhaft aufgebracht, z. B. aufgeklebt oder mit Verbindungselementen befestigt, wird.

In den in Fig. 4 und Fig. 5 dargestellten Schnitten ist erkennbar, dass die Aussparungen 36 die Thermoden-Kontaktschicht 30 von der Thermoden-Kontaktfläche 32 bis zu der gegenüberliegenden Stirnfläche der Thermoden-Kontaktschicht 30 durchlaufen. Es ist möglich, dass ein Betrachter der Thermoden-Kontaktschicht 30 in Blickrichtung senkrecht zu der dielektrischen Schicht 10 durch die Aussparungen 36 hindurch das dielektrische Substrat 10 erkennt. Durch Farbgebung der Thermoden-Kontaktschicht 30 bzw. der Thermoden-Kontaktfläche 32 und der dielektrischen Schicht 10 und/oder Formgebung der Aussparungen 36 kann so einem Betrachter oder Erkennungssystem eine optische Information bereitgestellt werden, z. B. ein Muster, eine Grafik, ein Zeichen wie ein Symbol, ein Buchstabe, eine Zahl.

Es ist auch möglich, dass durch die Wärmeabgabe der Thermode 60 an die Thermoden-Kontaktschicht 30 und die daran angrenzende dielektrischen Schicht 10 Material der dielektrischen Schicht schmilzt und im flüssigen Zustand zumindest teilweise in die Aussparungen 36 läuft. Auf diese Weise kann sich eine verbesserte Verbindung der Thermoden-Kontaktschicht 30 und der dielektrischen Schicht 10 ergeben. Ebenso ist es möglich, dass eine in einem nachfolgenden Beschichtungsverfahren auf das mehrschichtige Folienelement 1 aufgebrachte Schicht, z. B. eine Oberflächenschutzschicht aus einem Klarlack oder eine Laminierfolie, sich zumindest teilweise in die Aussparungen 36 hinein erstreckt und/oder über eine oder mehrere Aussparungen 36 mit der dielektrischen Schicht 10 verbunden ist. Dadurch kann eine Zwischenschichthaftung erzielt werden.

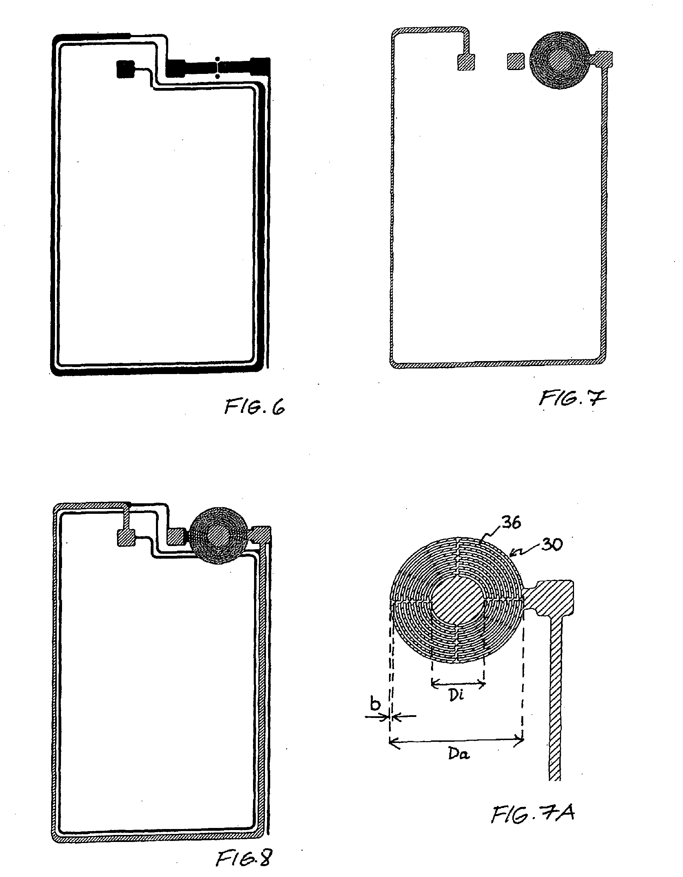

Fig. 6 zeigt, zur besseren Veranschaulichung des Ausführungsbeispiels auf dem Zeichnungsblatt, nochmals die auf einer Vorderseite einer dielektrischen Schicht angeordnete erste elektrisch leitfähige Schicht gemäß Fig. 1.

Fig. 7 zeigt die zweite elektrisch leitfähige Schicht nach Fig. 2 zusammen mit einem weiteren Ausführungsbeispiel der Thermoden-Kontaktschicht. Wie in Fig. 7A vergrößert dargestellt, ist die Thermoden-Kontaktschicht 30 als eine kreisrunde Scheibe mit einer Dicke d und einem Außendurchmesser Da ausgebildet, die in einem ringförmigen Bereich mit einem Innendurchmesser Di und einem Außendurchmesser Da Aussparungen 36 in Form von 90°-Bögen mit einer Breite b aufweist, die in jeweils konstantem Abstand zu der Mittelachse der scheibenförmigen Thermoden-Kontaktschicht 30 verlaufen. An den Winkelpositionen bei 0°, 90°, 180° und 270° verlaufen von dem Innendurchmesser Di zu dem Außendurchmesser Da durchgehende Stege, an denen die bogenförmigen Aussparungen 36 jeweils enden. Durch die Aussparungen 36 und die Stege bildet die Thermoden-Kontaktschicht 30 in dem ringförmigen Bereich konzentrisch verlaufende Kreisringe mit der Breite b aus. Typische und besonders vorteilhafte (in der Tabelle mit "bevorzugt" gekennzeichnet) Werte der Schichtdicke d, des Außendurchmessers Da, des Innendurchmessers Di, und der Breite b für das vorliegende Ausführungsbeispiel der Thermoden-Kontaktschicht 30 sind in Spalte 3 der Tabelle angegeben.

Fig. 8 zeigt eine überlagerte Projektion der Schichten nach Fig. 6 und Fig. 7, senkrecht zu der dielektrischen Schicht gesehen. Die Darstellung entspricht der Darstellung in der Fig. 3, auf deren Erläuterung verwiesen wird.

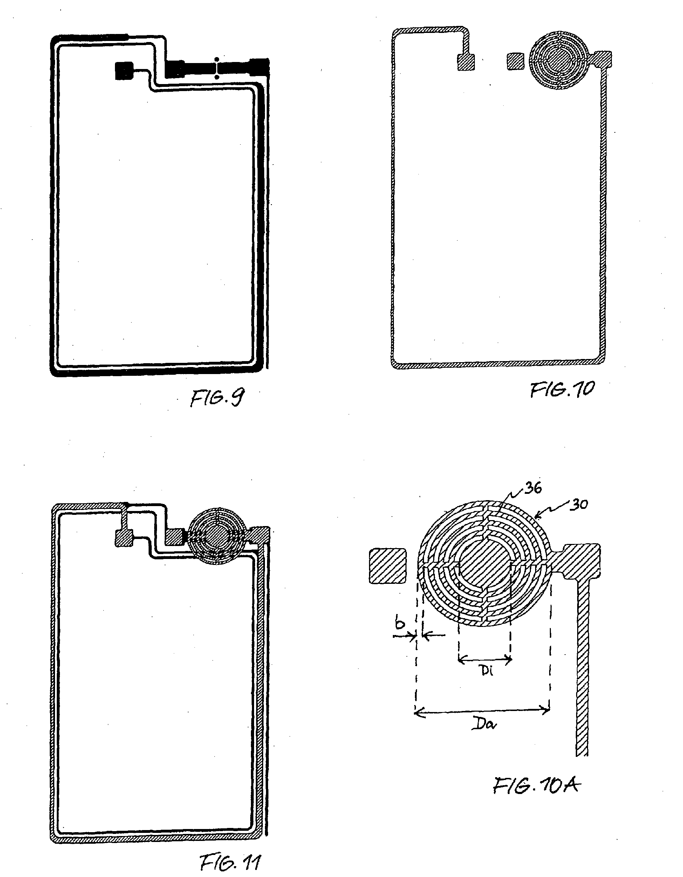

Fig. 9 zeigt, zur besseren Veranschaulichung des Ausführungsbeispiels auf dem Zeichnungsblatt, nochmals die auf einer Vorderseite einer dielektrischen Schicht angeordnete erste elektrisch leitfähige Schicht gemäß Fig. 1.

Fig. 10 zeigt die zweite elektrisch leitfähige Schicht nach Fig. 2 zusammen mit einem weiteren Ausführungsbeispiel der Thermoden-Kontaktschicht 30. Fig. 10A zeigt einen vergrößerten Ausschnitt der Fig. 10 mit einer Darstellung der Thermoden-Kontaktschicht 30. Das Ausführungsbeispiel der Thermoden-Kontaktschicht 30 entspricht weitgehend dem Ausführungsbeispiel der Fig. 7 und Fig. 7A, auf das verwiesen wird, lediglich mit davon abweichenden Abmessungen. Typische und besonders vorteilhafte (in der Tabelle mit "bevorzugt" gekennzeichnet) Werte der Schichtdicke d, des Außendurchmessers Da, des Innendurchmessers Di, und der Breite b für das vorliegende Ausführungsbeispiel der Thermoden-Kontaktschicht 30 sind in Spalte 4 der Tabelle angegeben.

Fig. 11 zeigt eine überlagerte Projektion der Schichten nach Fig. 9 und Fig. 10, senkrecht zu der dielektrischen Schicht gesehen. Die Darstellung entspricht der Darstellung in der Fig. 3, auf deren Erläuterung verwiesen wird.

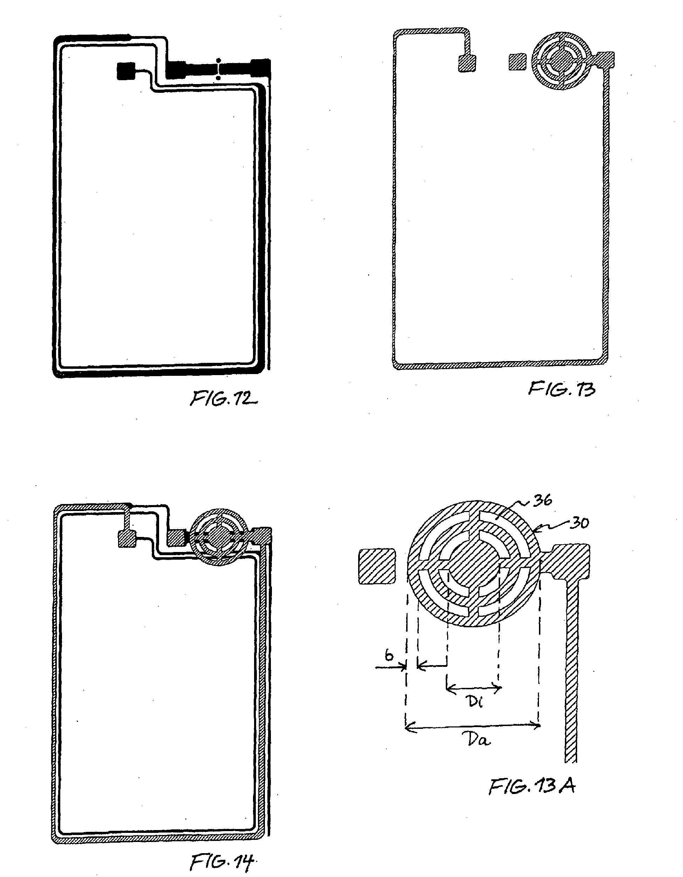

Fig. 12 zeigt, zur besseren Veranschaulichung des Ausführungsbeispiels auf dem Zeichnungsblatt, nochmals die auf einer Vorderseite einer dielektrischen Schicht angeordnete erste elektrisch leitfähige Schicht gemäß Fig. 1.

Fig. 13 zeigt die zweite elektrisch leitfähige Schicht nach Fig. 2 zusammen mit einem weiteren Ausführungsbeispiel der Thermoden-Kontaktschicht 30. Fig. 13A zeigt einen vergrößerten Ausschnitt der Fig. 13 mit einer Darstellung der Thermoden-Kontaktschicht 30. Das Ausführungsbeispiel der Thermoden-Kontaktschicht 30 entspricht weitgehend dem Ausführungsbeispiel der Fig. 7 und Fig. 7A, auf das verwiesen wird, lediglich mit davon abweichenden Abmessungen. Typische und besonders vorteilhafte (in der Tabelle mit "bevorzugt" gekennzeichnet) Werte der Schichtdicke d, des Außendurchmessers Da, des Innendurchmessers Di, und der Breite b für das vorliegende Ausführungsbeispiel der Thermoden-Kontaktschicht 30 sind in der Spalte 5 der Tabelle angegeben.

Fig. 14 zeigt eine überlagerte Projektion der Schichten nach Fig. 12 und Fig. 13, senkrecht zu der dielektrischen Schicht gesehen. Die Darstellung entspricht der Darstellung in der Fig. 3, auf deren Erläuterung verwiesen wird.

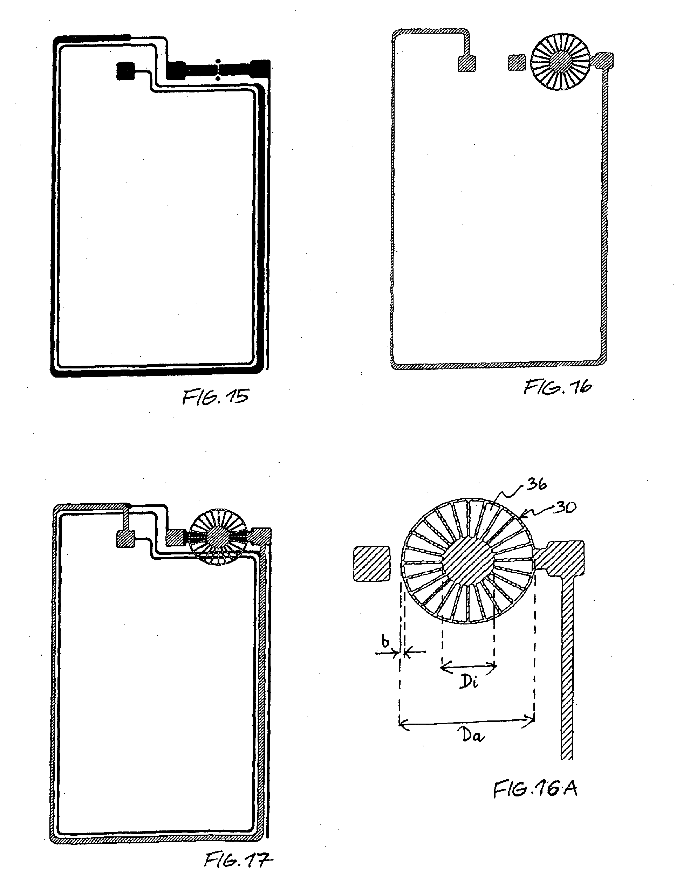

Fig. 15 zeigt, zur besseren Veranschaulichung des Ausführungsbeispiels auf dem Zeichnungsblatt, nochmals die auf einer Vorderseite einer dielektrischen Schicht angeordnete erste elektrisch leitfähige Schicht gemäß Fig. 1.

Fig. 16 zeigt die zweite elektrisch leitfähige Schicht nach Fig. 2 zusammen mit einem weiteren Ausführungsbeispiel der Thermoden-Kontaktschicht 30. Wie in Fig. 16A vergrößert dargestellt, ist die Thermoden-Kontaktschicht 30 ist als eine kreisrunde Scheibe mit einer Dicke d und einem Außendurchmesser Da ausgebildet, die in einem hohlzylinderförmigen Bereich mit einem Innendurchmesser Di und einem Außendurchmesser Da - 2b vierundzwanzig keilförmige, radial angeordnete Aussparungen 36 aufweist, wobei die zulaufenden Enden der Keile zu der Scheibenachse hin orientiert sind und parallel zu der Scheibenachse verlaufen. Typische und besonders vorteilhafte (in der Tabelle mit "bevorzugt" gekennzeichnet) Werte der Schichtdicke d, des Außendurchmessers Da, des Innendurchmessers Di, und der Breite b für das vorliegende Ausführungsbeispiel der Thermoden-Kontaktschicht 30 sind in der Spalte 6 der Tabelle angegeben.

Fig. 17 zeigt eine überlagerte Projektion der Schichten nach Fig. 15 und Fig. 16, senkrecht zu der dielektrischen Schicht gesehen. Die Darstellung entspricht der Darstellung in der Fig. 3, auf deren Erläuterung verwiesen wird.

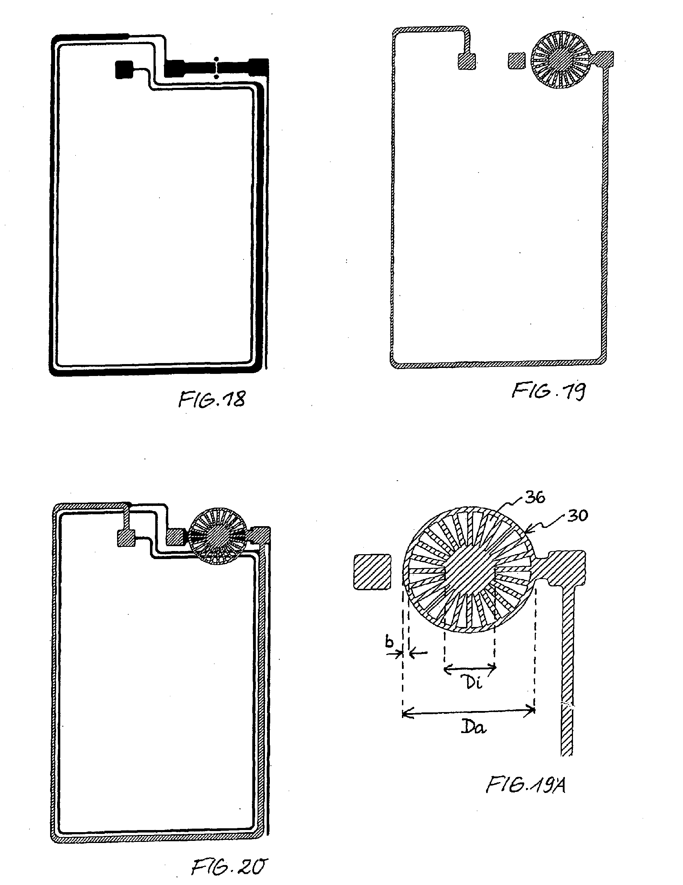

Fig. 18 zeigt, zur besseren Veranschaulichung des Ausführungsbeispiels auf dem Zeichnungsblatt, nochmals die auf einer Vorderseite einer dielektrischen Schicht angeordnete erste elektrisch leitfähige Schicht gemäß Fig. 1.

**Tabelle:**

| 1 | 2 | 3 | 4 | 5 | 6 | 7 |
|---|---|---|---|---|---|---|
| | Fig. 2A | Fig. 7A | Fig. 10A | Fig. 13A | Fig. 16A | Fig. 19A |
| d [µm] | 2-50 | 2-50 | 2-50 | 2-50 | 2-50 | 2-50 |
| d [µm], bevorzugt | 10 | 10 | 10 | 10 | 10 | 10 |
| Da [mm] | 7-20 | 7-20 | 7-20 | 7-20 | 7-20 | 7-20 |
| Da [mm], bevorzugt | 13 | 13 | 13 | 13 | 13 | 13 |
| Di [mm] | 2-10 | 2-10 | 2-10 | 2-10 | 2-10 | 2-10 |
| Di [mm], bevorzugt | 5 | 5 | 5 | 5 | 5 | 5 |
| b [mm] | 0,2-2 | 0,1-2 | 0,2-2 | 0,2-2 | 0,1-2 | 0,2-2 |
| b [mm], bevorzugt | 1 | 0,25 | 0,5 | 1 | 0,25 | 0,5 |

Fig. 19 zeigt die zweite elektrisch leitfähige Schicht nach Fig. 2 zusammen mit einem weiteren Ausführungsbeispiel der Thermoden-Kontaktschicht 30. Fig. 19A zeigt einen vergrößerten Ausschnitt der Fig. 19 mit einer Darstellung der Thermoden-Kontaktschicht 30. Das Ausführungsbeispiel der Thermoden-Kontaktschicht 30 entspricht weitgehend dem Ausführungsbeispiel der Fig. 2 und Fig. 2A, auf das verwiesen wird, lediglich mit davon abweichenden Abmessungen. Typische und besonders vorteilhafte (in der Tabelle mit "bevorzugt" gekennzeichnet) Werte der Schichtdicke d, des Außendurchmessers Da, des Innendurchmessers Di, und der Breite b für das vorliegende Ausführungsbeispiel der Thermoden-Kontaktschicht 30 sind in der Spalte 7 der Tabelle angegeben.

Fig. 20 zeigt eine überlagerte Projektion der Schichten nach Fig. 18 und Fig. 19, senkrecht zu der dielektrischen Schicht gesehen. Die Darstellung entspricht der Darstellung in der Fig. 3, auf deren Erläuterung verwiesen wird.

Neben den dargestellten und beschriebenen Strukturierungen der Thermoden-Kontaktschicht sind weitere Formgebungen wie z. B. lineare oder kreisförmige Gitterstrukturen oder nicht untereinander verbundene Strukturen denkbar, die aufgrund eines ähnlichen Flächenbelegungsgrades zu gleichwertigen Ergebnissen kommen können.

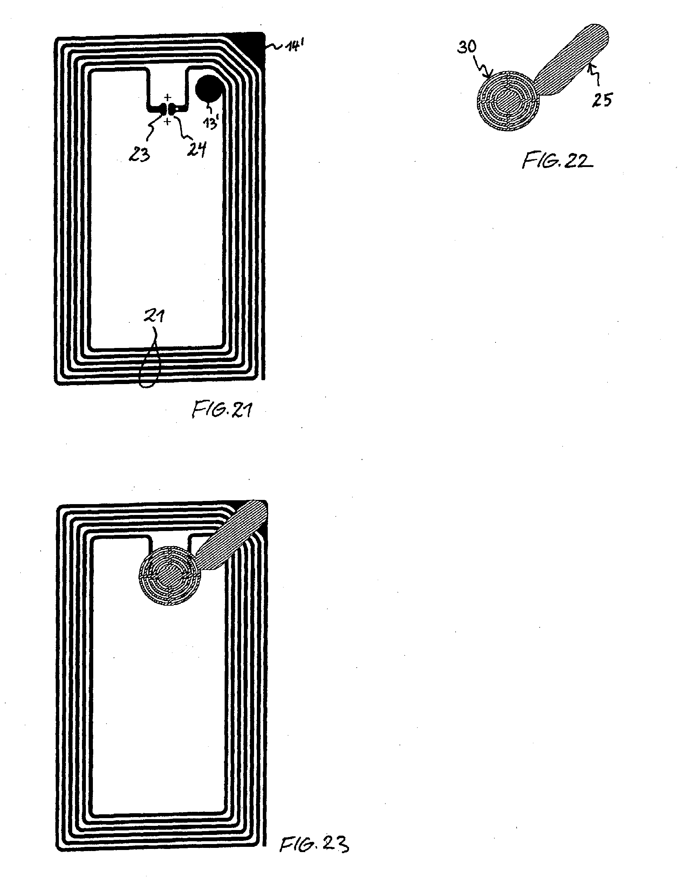

Die Fig. 21 bis 23 zeigen eine weitere vorteilhafte Ausführungsform eines erfindungsgemäßen Folienelements. Dabei zeigt Fig. 21 eine Vorderseite einer dielektrischen Schicht mit einer Leiterbahn 21, mit vorderseitigen Kontaktierungsflächen 13', 14' einer ersten und einer zweiten Durchkontaktierung 13, 14 sowie mit innerhalb der Leiterbahn 21 liegenden Chip-Kontaktflächen 23, 24 zum Kontaktieren eines (hier nicht dargestellten) Chips. Fig. 22 zeigt eine zu Fig. 21 korrespondierende Rückseite einer dielektrischen Schicht mit einer Thermoden-Kontaktschicht 30 und einem Verbindungsbereich 25. Die Rückseite umfasst dabei in diesem Ausführungsbeispiel keine weitere Leiterbahn, sondern im Wesentlichen nur die Thermoden-Kontaktschicht 30 und den Verbindungsbereich 25 zwischen den Durchkontaktierungen 13, 14. Man spricht in diesem Zusammenhang von einer einseitigen Antenne. Fig. 23 zeigt eine überlagerte Projektion der Schichten nach Fig. 21 und Fig. 22, senkrecht zu der dielektrischen Schicht gesehen.

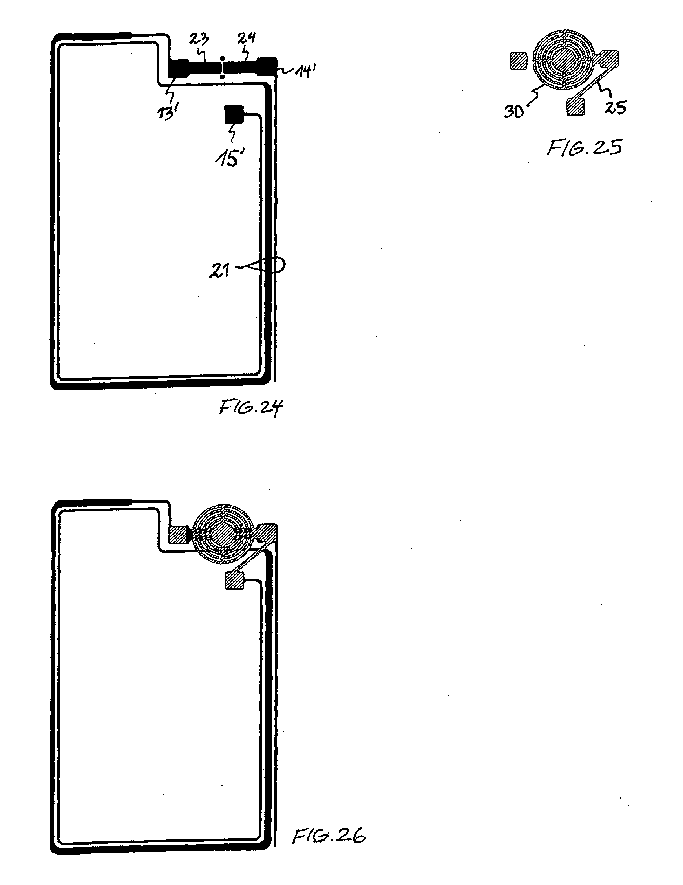

Die Fig. 24 bis 26 zeigen eine weitere vorteilhafte Ausführungsform eines erfindungsgemäßen Folienelements. Dabei zeigt Fig. 24 - ähnlich zu Fig. 21 - eine Vorderseite einer dielektrischen Schicht mit einer Leiterbahn 21, mit vorderseitigen Kontaktierungsflächen 13' bis 15' von Durchkontaktierungen 13 bis 15 und mit Chip-Kontaktflächen 23 und 24 zum Kontaktieren eines (hier nicht dargestellten) Chips. In diesem Fall ist die dritte Durchkontaktierung 15 nicht auf einer Linie mit der ersten 13 und der zweiten Durchkontaktierung 14 angeordnet, sondern wurde unter diesen platziert.

Fig. 25 zeigt eine zu Fig. 22 korrespondierende Rückseite einer dielektrischen Schicht mit einer Thermoden-Kontaktschicht 30 und einem Verbindungsbereich 25. Die Rückseite umfasst dabei in diesem Ausführungsbeispiel keine weitere Leiterbahn, sondern im Wesentlichen nur die Thermoden-Kontaktschicht 30 und den Verbindungsbereich 25 zwischen den Durchkontaktierungen 14, 15. Man spricht in diesem Zusammenhang wieder von einer einseitigen Antenne. Fig. 26 zeigt eine überlagerte Projektion der Schichten nach Fig. 24 und Fig. 25, senkrecht zu der dielektrischen Schicht gesehen.

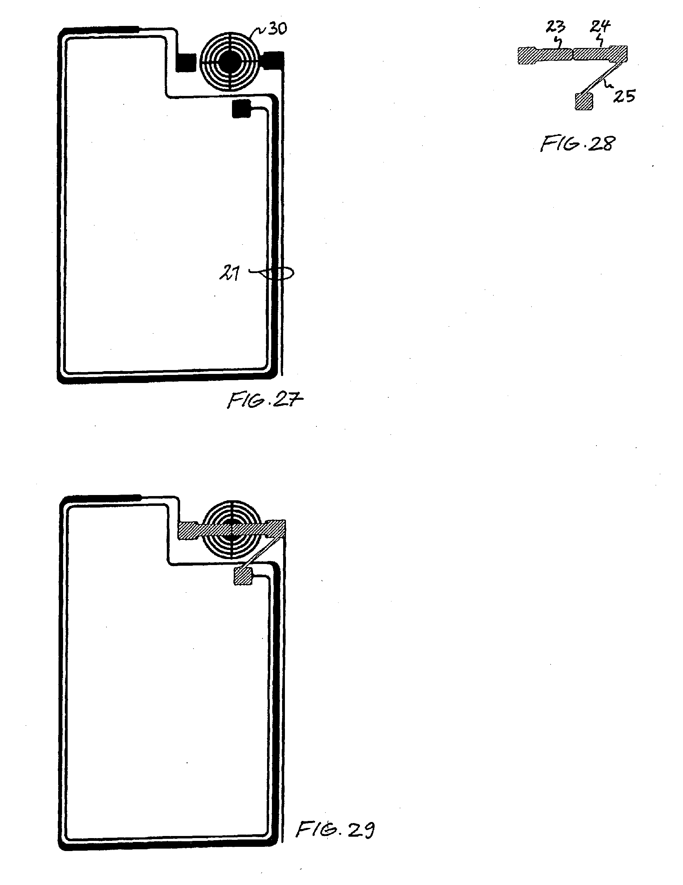

Die Fig. 27 bis 29 zeigen eine weitere vorteilhafte Ausführungsform eines erfindungsgemäßen Folienelements. Dabei zeigt Fig. 27 eine Rückseite einer dielektrischen Schicht mit einer Leiterbahn 21 sowie mit einer Thermoden-Kontaktschicht 30. Die Thermoden-Kontaktschicht 30 kann dabei elektrisch mit der Leiterbahn 21 verbunden sein (wie dargestellt) oder kann davon separat, d. h. elektrisch isoliert angeordnet sein. Fig. 28 zeigt eine Vorderseite einer dielektrischen Schicht mit Chip-Kontaktflächen 23 und 24 für eine Kontaktierung eines (hier nicht dargestellten) Chips. In diesem Ausführungsbeispiel besitzt die Vorderseite keine weitere Leiterbahn und ist im Wesentlichen aus den Chip-Kontaktierungsbereichen 23, 24 und dem Verbindungsbereich 25 zwischen den Durchkontaktierungen aufgebaut. Fig. 29 zeigt eine überlagerte Projektion der Schichten nach Fig. 27 und Fig. 28, senkrecht zu der dielektrischen Schicht gesehen.

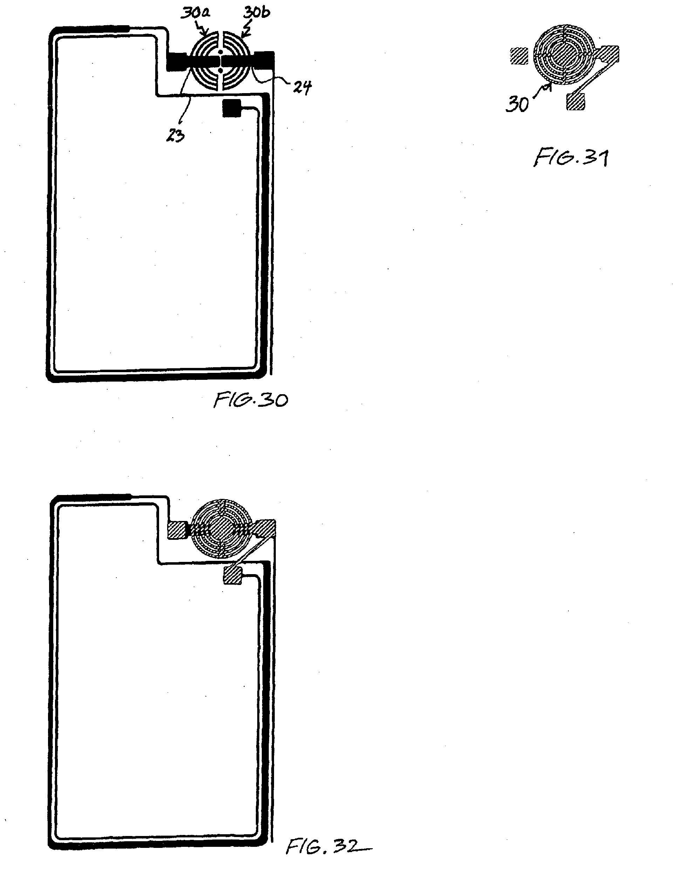

Die Fig. 30 bis 32 zeigen eine weitere besondere vorteilhafte Ausführungsform eines erfindungsgemäßen Folienelements. Dabei zeigt Fig. 30 eine Vorderseite einer dielektrischen Schicht - ähnlich der Fig. 24 - mit dem Unterschied, dass um die Chip-Kontaktflächen 23 und 24 herum, für eine frontseitige Kontaktierung eines (hier nicht dargestellten) Chips, zusätzliche frontseitige Thermoden-Kontaktschichten in Form zweier Teilbereiche 30a, 30b, aufgebracht wurden. In Kombination mit der rückseitigen Thermoden-Kontaktschicht 30 ist mit diesem Ausführungsbeispiel eine sehr homogene Temperaturverteilung erzielbar. Fig. 32 zeigt in diesem Ausführungsbeispiel eine überlagerte Projektion der Schichten nach Fig. 30 und Fig. 31 senkrecht zu der dielektrischen Schicht gesehen.

Es ist möglich, dass zunächst eine elektrische Kontakte aufweisende Seite eines Chips und/oder der Chip-Kontaktflächen 23, 24 mit einem thermisch aktivierbaren Verbindungsmittel beschichtet wird, danach die die elektrischen Kontakte aufweisende Seite des Chips auf den Chip-Kontaktflächen 23, 24 angeordnet wird, und nachfolgend eine frontseitige Thermode die Teilbereiche 30a, 30b der frontseitigen Thermoden-Kontaktschicht mit Wärme beaufschlagt oder direkt kontaktiert und eine rückseitige Thermode die rückseitigen Thermoden-Kontaktschicht 30 beaufschlagt, vorzugsweise kontaktiert. Auf diese Weise wird das thermisch aktivierbare Verbindungsmittel aktiviert. Nach der Aktivierung des Verbindungsmittels werden die Thermoden von den front- und rückseitigen Thermoden-Kontaktflächen 30a, 30b, 30 getrennt, vorzugsweise abgehoben.

Zu erwähnen ist in diesem Zusammenhang auf der einen Seite, dass im Falle einer geteilten Thermoden-Kontaktschicht - entsprechend der Ausführungen nach Fig. 30 - auf eine rückseitige Thermoden-Kontaktschicht 30 verzichtet werden kann, da bereits die Wärmeübertragung von den Teilbereichen 30a, 30b der vorderseitigen geteilte Thermoden-Kontaktschicht zu den Chip-Kontaktflächen 23, 24 zur Aktivierung der Verbindungsmittels ausreicht. Ausführungen mit alleiniger geteilter frontseitiger oder auch rückseitiger Thermoden-Kontaktschicht sind daher möglich. Auf der anderen Seite ist zu erwähnen, dass die Teilung der Thermoden-Kontaktschicht nicht nur auf die Ausführung nach Fig. 30 beschränkt ist, sondern beliebig viele Teilbereiche aufweisen kann. Vorteilhaft ist jedoch in diesem Fall eine Zweiteilung in der dargestellten Art und Weise mit einer direkten Verbindung zu den Chip-Kontaktflächen 23 und 24.

### Bezugszeichenliste

- 1: mehrschichtiges Folienelement
- 10: dielektrische Schicht
- 10R: Rückseite von 10
- 10V: Vorderseite von 10
- 11: erste ein erstes Bauelement bildende Schicht, erste elektrisch leitfähige Schicht
- 12: zweite ein erstes Bauelement bildende Schicht, zweite elektrisch leitfähige Schicht
- 13: erste Durchkontaktierung
- 13', 13": vorder- und rückseitige Kontaktierungsflächen von 13
- 14: zweite Durchkontaktierung
- 14', 14": vorder- und rückseitige Kontaktierungsflächen von 14
- 15: dritte Durchkontaktierung
- 15', 15": vorder- und rückseitige Kontaktierungsflächen von 15
- 20: Leiterbahn
- 21: erster Leiterbahnabschnitt
- 22: zweiter Leiterbahnabschnitt
- 23: erste Bauelement-Kontaktfläche, erste Chip-Kontaktfläche
- 24: zweite Bauelement-Kontaktfläche, zweite Chip-Kontaktfläche
- 25: Verbindungsbereich
- 30: Thermoden-Kontaktschicht
- 30a, 30b: Teilbereich der Thermoden-Kontaktschicht
- 32: Thermoden-Kontaktfläche
- 36: Aussparung von 30
- 50: zweites Bauelement, Chip
- 60: Thermode (unten)
- 61: Thermode (oben, Chipseite)
- b: Linienbreite von 30
- d: Schichtdicke von 30
- Da: äußerer Durchmesser von 30
- Di: innerer Durchmesser von 30

## Patentansprüche

1. Mehrschichtiges Folienelement (1) mit einer dielektrischen Schicht (10), die eine Vorderseite (10V) und eine der Vorderseite (10V) gegenüberliegende Rückseite (10R) aufweist, wobei das Folienelement (1) eine ein erstes Bauelement bildende Schicht (11, 12) und mindestens eine auf der Vorderseite (10V) angeordnete, mit dem ersten Bauelement verbundene Bauelement-Kontaktfläche (23, 24) zum Anordnen eines zweiten Bauelements (50) aufweist, wobei das Folienelement (1) mindestens eine auf der dielektrischen Schicht (10) angeordnete Thermoden-Kontaktschicht (30) aufweist, die, senkrecht zu der dielektrischen Schicht (10) gesehen, im Bereich der mindestens einen Bauelement-Kontaktfläche (23, 24) angeordnet ist und auf einer von der dielektrischen Schicht (10) abgewandten Seite der mindestens einen Thermoden-Kontaktschicht (30) eine Thermoden-Kontaktfläche (32), die eine äußere Oberfläche des Folienelements (1) bildet, aufweist,
**dadurch gekennzeichnet,**
**dass** die das erste Bauelement bildende Schicht (11, 12) eine Metallschicht mit einer Dicke von 1 µm bis 50 µm ist, und dass die Thermoden-Kontaktschicht (30) ebenfalls als eine Metallschicht ausgebildet ist.

2. Mehrschichtiges Folienelement (1) nach Anspruch 1,
wobei die das erste Bauelement bildende Schicht (11, 12) eine Metallschicht mit einer Schichtdicke von 5 µm bis 15 µm ist.

3. Mehrschichtiges Folienelement (1) nach einem der Ansprüche 1 oder 2,
wobei das erste Bauelement eine Antennenstruktur ist.

4. Mehrschichtiges Folienelement (1) nach einem der vorhergehenden Ansprüche,
wobei die mindestens eine Bauelement-Kontaktfläche (23, 24) mit dem ersten Bauelement elektrisch verbunden ist und/oder eine Bauelement-Kontaktfläche (23, 24) eine Chip-Kontaktfläche zum Anordnen eines elektronischen Mikrochips (50) ist.

5. Mehrschichtiges Folienelement (1) nach einem der vorhergehenden Ansprüche,
wobei die mindestens eine Thermoden-Kontaktschicht (30) als eine auf der Vorderseite (10V) angeordnete vorderseitige Thermoden-Kontaktschicht, die die mindestens eine Bauelement-Kontaktfläche (23, 24) zumindest bereichsweise umschließt, und/oder als eine auf der Rückseite (10R) angeordnete rückseitige Thermoden-Kontaktschicht, die die mindestens eine Bauelement-Kontaktfläche (23, 24), senkrecht zu der dielektrischen Schicht (10) gesehen, zumindest bereichsweise überlappt und/oder umschließt, ausgebildet ist.

6. Mehrschichtiges Folienelement (1) nach einem der vorhergehenden Ansprüche,
wobei die mindestens eine Thermoden-Kontaktschicht (30) aus einem Material mit einer Wärmeleitfähigkeit von größer als 50 W/(m K) ausgebildet ist.

7. Mehrschichtiges Folienelement (1) nach einem der vorhergehenden Ansprüche,
wobei die das erste Bauelement bildende Schicht eine Metallschicht aus Eisen, Kupfer, Aluminium, Nickel, Silber, Gold, Platin, Zinn, Zink oder einer Legierung dieser Metalle und / oder ein Mehrschichtsystem ist.

8. Mehrschichtiges Folienelement (1) nach einem der vorhergehenden Ansprüche,
wobei die mindestens eine Thermoden-Kontaktfläche (32), in der Ebene der dielektrischen Schicht gemessen, eine maximale Ausdehnung im Bereich von 2 bis 50 mm, insbesondere von 5 bis 25 mm, aufweist und/ oder wobei die mindestens eine Thermoden-Kontaktschicht (30) eine maximale Schichtdicke (d) im Bereich von 1 bis 50 µm, insbesondere von 6 bis 14 µm, aufweist.

9. Mehrschichtiges Folienelement (1) nach einem der vorhergehenden Ansprüche,
wobei die das erste Bauelement bildende Schicht (11, 12) eine auf der Vorderseite (10V) angeordnete erste Schicht (11), eine auf der Rückseite (10R) angeordnete zweite Schicht (12) und eine oder mehrere die dielektrische Schicht (10) durchdringende Durchkontaktierungen (13, 14, 15), mittels der die erste Schicht (11) und die zweite Schicht (12) miteinander vorzugsweise elektrisch leitend verbunden sind, aufweist, wobei die mindestens eine Thermoden-Kontaktschicht (30) und die eine oder mehreren Durchkontaktierungen (13, 14, 15), senkrecht zu der dielektrischen Schicht (10) gesehen, ohne gegenseitige Überlappung angeordnet sind, vorzugsweise einen Abstand von mindestens 200 µm aufweisen.

10. Mehrschichtiges Folienelement (1) nach einem der vorhergehenden Ansprüche,
wobei die Thermoden-Kontaktfläche (32), senkrecht zu der dielektrischen Schicht (10) gesehen, eine oder mehrere die mindestens eine Thermoden-Kontaktschicht (30) vollständig durchdringende Aussparungen (36) aufweist, wobei vorzugsweise die Aussparungen und/oder die die Aussparungen umgebende Thermoden-Kontaktfläche (32) eine optische Information bereitstellen.

11. Mehrschichtiges Folienelement (1) nach einem der vorhergehenden Ansprüche,
wobei die Thermoden-Kontaktfläche (32) ein Oberflächenrelief aufweist, das vorzugsweise einen optischen Effekt hervorruft.

12. Mehrschichtiges Folienelement (1) nach einem der vorhergehenden Ansprüche,
wobei die mindestens eine Thermoden-Kontaktschicht (30) mit der das erste Bauelement bildenden Schicht (11, 12) und/oder der mindestens einen Bauelement-Kontaktfläche (23, 24) elektrisch leitend verbunden ist oder von der das erste Bauelement bildenden Schicht (11, 12) und/oder der mindestens einen Bauelement-Kontaktfläche (23, 24) elektrisch isoliert ist.

13. Mehrschichtiges Folienelement (1) nach einem der vorhergehenden Ansprüche,
wobei die mindestens eine Thermoden-Kontaktschicht (30) einen Teil eines elektrischen Bauelements des Folienelements (1) bildet.

14. Verfahren zum Befestigen eines zweiten Bauelements (50) auf einem mehrschichtigen Folienelement (1) nach einem der Ansprüche 1 bis 13, wobei das Verfahren die Schritte umfasst:
Beschichten einer Kontaktflächen aufweisenden Seite des zweiten Bauelements (50) und/oder der mindestens einen Bauelement-Kontaktfläche (23, 24) mit einem thermisch aktivierbaren Verbindungsmittel, vorzugsweise einem thermisch aktivierbaren, insbesondere leitfähigen Klebstoff;
Anordnen der die Kontaktflächen aufweisenden Seite des zweiten Bauelements (50) auf der mindestens einen Bauelement-Kontaktfläche (23, 24);
Kontaktieren der mindestens einen Thermoden-Kontaktfläche (32) mit einer Thermode (60) zur Aktivierung des Verbindungsmittels; und
Trennen der Thermode (60) von der mindestens einen Thermoden-Kontaktfläche (32) nach der Aktivierung des Verbindungsmittels.

15. Verfahren nach Anspruch 14,
wobei das Verfahren ferner den folgenden Schritt umfasst:
Durchtrennen einer elektrisch leitenden Verbindung zwischen der mindestens einen Thermoden-Kontaktschicht (30) und der das erste Bauelement bildenden Schicht (11, 12) und/oder der mindestens einen Bauelement-Kontaktfläche (23, 24).

## Claims

1. Multilayer film element (1) having a dielectric layer (10) which has a front side (10V) and a back side (10R) which lies opposite the front side (10V), wherein the film element (1) has a layer (11, 12) which forms a first component and at least one component contact surface (23, 24) which is arranged on the front side (10V) and is connected to the first component for the arrangement of a second component (50), wherein the film element (1) has at least one thermode contact layer (30) arranged on the dielectric layer (10), which, seen perpendicularly to the dielectric layer (10), is arranged in the region of the at least one component contact surface (23, 24) and has a thermode contact surface (32) which forms an outer surface of the film element (1) on a side of the at least one thermode contact layer (30) which faces away from the dielectric layer (10),
**characterised in that**,
the layer (11, 12) forming the first component is a metallic layer having a thickness from 1µm to 50µm, and that the thermode contact layer (30) is likewise formed as a metallic layer.

2. Multilayer film element (1) according to claim 1,
wherein the layer (11, 12) forming the first component is a metallic layer having a layer thickness from 5µm to 15µm.

3. Multilayer film element (1) according to one of claims 1 or 2,
wherein the first component is an antenna structure.

4. Multilayer film element (1) according to one of the preceding claims,
wherein the at least one component contact surface (23, 24) is electrically connected to the first component and/or a component contact surface (23, 24) is a chip contact surface for the arrangement of an electronic microchip (50).

5. Multilayer film element (1) according to one of the preceding claims,
wherein the at least one thermode contact layer (30) is formed as a front-side thermode contact layer which is arranged on the front side (10V) and which encloses the at least one component contact surface (23, 24) at least in regions, and/or as a back-side thermode contact layer which is arranged on the back side (10R) and which overlaps and/or encloses the at least one component contact surface (23, 24), seen perpendicularly to the dielectric layer (10), at least in regions.

6. Multilayer film element (1) according to one of the preceding claims,
wherein the at least one thermode contact layer (30) is formed from a material having a thermal conductivity of greater than 50 W/(m K).

7. Multilayer film element (1) according to one of the preceding claims,
wherein the layer forming the first component is a metallic layer made from iron, copper, aluminium, nickel, silver, gold, platinum, tin, zinc or an alloy of these metals and/or a multilayer system.

8. Multilayer film element (1) according to one of the preceding claims,
wherein the at least one thermode contact surface (32), measured in the plane of the dielectric layer, has a maximum expansion in the range from 2 to 50mm, in particular from 5 to 25mm, and/or wherein the at least one thermode contact layer (30) has a maximum layer thickness (d) in the range from 1 to 50µm, in particular from 6 to 14µm.

9. Multilayer film element (1) according to one of the preceding claims,
wherein the layer (11, 12) forming the first component has a first layer (11) arranged on the front side (10V), a second layer (12) arranged on the back side (10R) and one or more through-connections (13, 14) which penetrate the dielectric layer (10), by means of which the first layer (11) and the second layer (12) are connected to one another, preferably to be electrically conductive, wherein the at least one thermode contact layer (30) and the one or more through-connections (13, 14, 15), seen perpendicularly to the dielectric layer (10), are arranged without mutual overlapping, preferably have a spacing of at least 200µm.

10. Multilayer film element (1) according to one of the preceding claims,
wherein the thermode contact surface (32), seen perpendicularly to the dielectric layer (10), has one or more recesses (36) which completely penetrate the at least one thermode contact layer (30), wherein preferably the recesses and/or the thermode contact surface (32) surrounding the recesses provide optical information.

11. Multi-layer film element (1) according to one of the preceding claims,
wherein the thermode contact surface (32) has a surface relief which preferably causes an optical effect.

12. Multilayer film element (1) according to one of the preceding claims,
wherein the at least one thermode contact layer (30) is connected to the layer (11, 12) forming the first component and/or the at least one component contact surface (23, 24) to be electrically conductive or is electrically insulated by the layer (11, 12) forming the first component and/or the at least one component contact surface (23, 24).

13. Multilayer film element (1) according to one of the preceding claims,
wherein the at least one thermode contact layer (30) forms a part of an electrical component of the film element (1).

14. Method to fix a second component (50) to a multilayer film element (1) according to one of claims 1 to 13, wherein the method comprises the steps:
coating a side, which has contact surfaces, of the second component (50) and/or of the at least one component contact surface (23, 24) with a connecting means which is able to be thermally activated, preferably an adhesive which is able to be thermally activated and is, in particular, conductive;
arranging the side, which has contact surfaces, of the second component (50) on the at least one component contact surface (23, 24);
connecting the at least one thermode contact surface (32) to a thermode (60) for the activation of the connecting means; and
separating the thermode (60) from the at least one thermode contact surface (32) after the activation of the connecting means.

15. Method according to claim 14,
wherein the method furthermore comprises the following step:
separating an electrically conductive connection between the at least one thermode contact surface (30) and the layer (11, 12) forming the first component and/or the at least one component contact surface (23, 24).

## Revendications

1. Elément en feuille multicouches (1) comprenant une couche diélectrique (10) qui présente une face avant (10V) et une face arrière (10R) opposée à la face avant (10V), dans lequel l'élément film (1) présente une couche (11, 12) formant un premier élément structurel et au moins une face de contact de l'élément structurel (23, 24) disposée sur la face avant (10V), reliée au premier élément structurel, servant à agencer un deuxième élément structurel (50), dans lequel l'élément de feuille (1) présente au moins une couche de contact de thermodes (30) disposée sur la couche diélectrique (10) qui, vue perpendiculairement à la couche diélectrique (10), est disposée dans la zone de la face de contact de l'élément structurel (23, 24) au moins au nombre d'une, et présente, sur un côté opposé à la couche diélectrique (10) de la couche de contact de thermodes (30) au moins au nombre d'une, une face de contact de thermodes (32) qui forme une surface extérieure de l'élément film (1),
**caractérisé en ce que**
la couche (11, 12) formant le premier élément structurel est une couche métallique présentant une épaisseur allant de 1 µm à 50 µm, et **en ce que** la couche de contact de thermodes (30) est réalisée de la même manière sous la forme d'une couche métallique.

2. Elément en feuille multicouches (1) selon la revendication 1,
dans lequel la couche (11, 12) formant le premier élément structurel est une couche métallique présentant une épaisseur de couche allant de 5 µm à 15 µm.

3. Elément en feuille multicouches (1) selon l'une quelconque des revendications 1 ou 2,
dans lequel le premier élément structurel est une structure à antennes.

4. Elément en feuille multicouches (1) selon l'une quelconque des revendications précédentes,
dans lequel la face de contact d'élément structurel (23, 24) au moins au nombre d'une est reliée de manière électrique au premier élément structurel, et/ou en ce qu'une face de contact d'élément structurel (23, 24) est une face de contact à puce servant à recevoir une micropuce (50) électronique.

5. Elément en feuille multicouches (1) selon l'une quelconque des revendications précédentes,
dans lequel la couche de contact de thermodes (30) au moins au nombre d'une est réalisée sous forme d'une couche de contact de thermodes face avant disposée sur la face avant (10V), laquelle couche de contact de thermodes renferme au moins par endroits la face de contact de l'élément structurel (23, 24) au moins au nombre d'une, et/ou sous forme d'une couche de contact de thermodes face arrière disposée sur la face arrière (10R), laquelle couche de contact de thermodes chevauche et/ou renferme, au moins par endroits, vue perpendiculairement à la couche diélectrique (10), la face de contact de l'élément structurel (23, 24) au moins au nombre d'une.

6. Elément en feuille multicouches (1) selon l'une quelconque des revendications précédentes,
dans lequel la couche de contact de thermodes (30) au moins au nombre d'une est réalisée à partir d'un matériau présentant une conductivité thermique supérieure à 50 W/(mK).

7. Elément en feuille multicouches (1) selon l'une quelconque des revendications précédentes,
dans lequel la couche formant le premier élément structurel est une couche métallique en fer, cuivre, aluminium, nickel, argent, or, platine, étain, zinc ou en un alliage desdits métaux et/ou est un système multicouche.

8. Elément en feuille multicouches (1) selon l'une quelconque des revendications précédentes,
dans lequel la face de contact de thermodes (32) au moins au nombre d'une, mesurée dans le plan de la couche diélectrique, présente une extension maximale comprise dans la plage allant de 2 à 50 mm, en particulier dans la plage allant de 5 à 25 mm, et/ou dans lequel la couche de contact de thermodes (30) au moins au nombre d'une présente une épaisseur de couche maximale (d) comprise dans la plage allant de 1 à 50 um, en particulier dans la plage allant de 6 à 14 µm.

9. Elément en feuille multicouches (1) selon l'une quelconque des revendications précédentes,
dans lequel la couche (11, 12) formant le premier élément structurel présente une première couche (11) disposée sur la face avant (10V), une deuxième couche (12) disposée sur la face arrière (10R) et un ou plusieurs éléments de mise en contact (13, 14, 15) traversant la couche diélectrique (10), au moyen desquels la première couche (11) et la deuxième couche (12) sont reliées l'une à l'autre de préférence de manière électroconductrice, dans lequel la couche de contact de thermodes (30) au moins au nombre d'une et un ou plusieurs des éléments de mise en contact (13, 14, 15), vus perpendiculairement à la couche diélectrique (10), sont disposés sans chevauchement mutuel, présentent de préférence une distance d'au moins 200 µm.

10. Elément en feuille multicouches (1) selon l'une quelconque des revendications précédentes,
dans lequel la face de contact de thermodes (32) présente, vue perpendiculairement à la couche diélectrique (10), un ou plusieurs évidements (36) traversant intégralement la couche de contact de thermodes (30) au moins au nombre d'une, dans lequel de préférence les évidements et/ou la face de contact de thermodes (32) entourant les évidements fournissent une information optique.

11. Elément en feuille multicouches (1) selon l'une quelconque des revendications précédentes,
dans lequel la face de contact de thermodes (32) présente un relief en surface qui entraîne de préférence un effet optique.

12. Elément en feuille multicouches (1) selon l'une quelconque des revendications précédentes,
dans lequel la couche de contact de thermodes (30) au moins au nombre d'une est reliée de manière électroconductrice à la couche (11, 12) formant le premier élément structurel et/ou à la face de contact de l'élément structurel (23, 24) au moins au nombre d'une ou est isolée électriquement de la couche (11, 12) formant le premier élément structurel et/ou de la face de contact de l'élément structurel (23, 24) au moins au nombre d'une.

13. Elément en feuille multicouches (1) selon l'une quelconque des revendications précédentes,
dans lequel la couche de contact de thermodes (30) au moins au nombre d'une forme une partie d'un élément structurel électrique de l'élément multicouche en feuilles (1).

14. Procédé servant à fixer un deuxième élément structurel (50) sur un élément en feuille multicouches (1) selon l'une quelconque des revendications 1 à 13, dans lequel le procédé comprend les étapes consistant à :
revêtir un côté, présentant des faces de contact, du deuxième élément structurel (50) et/ou la face de contact de l'élément structurel (23, 24) au moins au nombre d'une d'un moyen d'assemblage pouvant être activé thermiquement, de préférence d'une substance adhésive pouvant être activée thermiquement, en particulier conductrice ;
agencer le côté du deuxième élément structurel (50) présentant les faces de contact sur la face de contact de l'élément structurel (23, 24) au moins au nombre d'une ;
établir un contact entre la face de contact de thermodes (32) au moins au nombre d'une et une thermode (60) aux fins de l'activation du moyen d'assemblage ; et
séparer la thermode (60) de la face de contact de thermodes (32) au moins au nombre d'une après l'activation du moyen d'assemblage.

15. Procédé selon la revendication 14,
dans lequel le procédé comprend en outre l'étape qui suit consistant à :
séparer une liaison électroconductrice entre la couche de contact de thermodes (30) au moins au nombre d'une et la couche (11, 12) formant le premier élément structurel et/ou la face de contact de l'élément structurel (23, 24) au moins au nombre d'une.
